# EUROPEAN PATENT APPLICATION

(11) **EP 4 390 653 A1**
(43) Date of publication of application: **26.06.2024**
(21) Application number: 23806587.4
(22) Date of filing: 16.03.2023
(51) Int. Cl.: G06F 3/06, G06F 9/30

(54) **WRITE DATA SIGNAL DELAY CONTROL METHOD AND APPARATUS, AND DEVICE AND MEDIUM**

(30) Priority: 20.05.2022 CN 202210548827
(71) Applicant: Tencent Technology (Shenzhen) Company Limited, Shenzhen, Guangdong, 518057 (CN)
(72) Inventor: QIANG, Peng, Shenzhen, Guangdong 518057 (CN)
(74) Representative: EP&C
(86) International application number: PCT/CN2023/081939
(87) International publication number: WO 2023/221627

(57) **Abstract**

The present application relates to a write data signal delay control method. The method comprises: performing working mode configuration on a register circuit in a memory by means of a host, so as to obtain a training register, which supports reading and writing (202); sending a sample write data signal to the memory by means of the host (204); sampling the sample write data signal by means of the memory on the basis of a sampling signal, and caching a sampled write data signal, which is obtained by means of sampling, into the training register (206); if the sampled write data signal, which is read by the host from the training register, is inconsistent with the sample write data signal, performing, on the basis of the sample write data signal, delay adjustment training on a write data delay control circuit, which is provided on the host, so as to obtain a trained write data delay control circuit (208); and performing signal offset adjustment on the write data signals, which are input, by means of the trained write data delay control circuit, so as to obtain a target write data signal, which is aligned with a sampling edge of the sampling signal and is to be written to the memory (210)

## Description

This application claims priority to Chinese Patent Application No. 2022105488270, filed with the China National Intellectual Property Administration on May 20, 2022 and entitled "METHOD AND APPARATUS FOR CONTROLLING DELAY OF WRITING-DATA SIGNALS, DEVICE, AND MEDIUM".

### FIELD OF THE TECHNOLOGY

This application relates to the field of computer technologies, and in particular, to a method and an apparatus for controlling delay of writing-data signals, a device, and a medium.

### BACKGROUND OF THE DISCLOSURE

In a high-bandwidth memory system, a host in the high-bandwidth memory system transmits a writing-data signal to a memory in the high-bandwidth memory system, so that corresponding write operation control of the memory may be implemented. However, during transmission of the writing-data signal to the memory by the host, since the transmission of the writing-data signal may be affected by factors such as an environmental change and a crosstalk between signals, a temporal offset of the writing-data signal from a sampling signal in the memory may be caused, and then an error in sampling of write data occurs. If the error in the sampling of the write data occurs, an error may occur in a write operation on the memory performed by the host, which may cause an error to occur in data written to the memory, and reduce operation stability of the memory.

### SUMMARY

Based on this, a method for controlling delay of writing-data signals and apparatus, a device, and a medium need to be provided to resolve the foregoing technical problems.

According to a first aspect, this application provides a method for controlling delay of writing-data signals, the method executable by a computer device and including::
configuring, through a host, an operating mode of a register circuit in a memory to obtain a training register which is readable and writable;
transmitting, through the host, a reference writing-data signal to the memory;
sampling, through the memory, the reference writing-data signal with a sampling signal to obtain a sampled writing-data signal, and caching the sampled writing-data signal into the training register;
training, in a case that the sampled writing-data signal read by the host from the training register is inconsistent with the reference writing-data signal, a circuit, which is configured to control the delay of writing-data signals with respect to the sampling signal, arranged on the host through adjusting a temporal offset applied by the circuit on the reference writing-data signal, until the sampled writing-data signal read by the host from the training register is consistent with the reference writing-data signal, to obtain a trained circuit; and
adjusting, through the trained circuit, a temporal offset applied on an inputted writing-data signal to obtain a target writing-data signal, where the target writing-data signal is aligned with a sampling edge of the sampling signal, and the target writing-data signal is configured to be written into the memory.

According to a second aspect, this application provides an apparatus for controlling delay of writing-data signals, including:
a configuration module, configured to configure, through a host, an operating mode of a register circuit in a memory to obtain a training register which is readable and writable;
a transmission module, configured to transmit, through the host, a reference writing-data signal to the memory;
a sampling module, configured to sample, through the memory, the reference writing-data signal with a sampling signal to obtain a sampled writing-data signal, and caching the sampled writing-data signal into the training register;
a training module, configured to train, in a case that the sampled writing-data signal read by the host from the training register is inconsistent with the reference writing-data signal, a circuit, which is configured to control the delay of writing-data signals with respect to the sampling signal, arranged on the host through adjusting a temporal offset applied by the circuit on the reference writing-data signal, until the sampled writing-data signal read by the host from the training register is consistent with the reference writing-data signal, to obtain a trained circuit; and
an adjustment module, configured to adjust, through the trained circuit, a temporal offset applied on an inputted writing-data signal to obtain a target writing-data signal, where the target writing-data signal is aligned with a sampling edge of the sampling signal, and the target writing-data signal is configured to be written into the memory.

According to a third aspect, this application provides a computer device, including a memory and one or more processors, the memory having computer-readable instructions stored therein, the one or more processors implementing the operations in the method embodiments of this application when executing the computer-readable instructions.

According to a fourth aspect, this application provides one or more computer-readable storage media, having computer-readable instructions stored therein, the computer-readable instructions, when executed by one or more processors, implementing the operations in the method embodiments of this application.

According to a fifth aspect, this application provides a computer program product, including computer-readable instructions, the computer-readable instructions, when executed by one or more processors, implementing the operations in the method embodiments of this application.

Details of one or more embodiments of this application are provided in the accompanying drawings and descriptions below. Other features, objectives, and advantages of this application become apparent from the specification, the accompanying drawings, and the claims.

To describe the technical solutions of the embodiments of this application more clearly, the following briefly describes the accompanying drawings required for describing the embodiments. Apparently, the accompanying drawings in the following description show merely some embodiments of this application, and a person of ordinary skill in the art may still derive other accompanying drawings from these accompanying drawings without creative efforts.

### BRIEF DESCRIPTION OF THE DRAWINGS

FIG. 1 is an application environment diagram of a method for controlling delay of writing-data signals according to an embodiment.
FIG. 2 is a schematic flowchart of a method for controlling delay of writing-data signals according to an embodiment.
FIG. 3 is a schematic diagram of a composition structure of a writing-data signal according to an embodiment.
FIG. 4 is a schematic diagram of transmission timing of a write instruction according to an embodiment.
FIG. 5 is a schematic diagram of a format of a writing-data signal according to an embodiment.
FIG. 6 is a schematic diagram of a format of a writing-data signal when a burst length is 2 according to an embodiment.
FIG. 7 is a schematic diagram of a format of a writing-data signal when a burst length is 4 according to an embodiment.
FIG. 8 is a schematic diagram of a transmission process of a writing-data signal according to an embodiment.
FIG. 9 is a schematic diagram of transmission timing of a read instruction according to an embodiment.
FIG. 10 is a schematic diagram of alignment of a writing-data signal with a sampling edge of a sampling signal according to an embodiment.
FIG. 11 is a schematic diagram of a configuration description table of a mode register according to an embodiment.
FIG. 12 is a schematic diagram of distribution of each reference sub-signal in a writing-data signal according to an embodiment.
FIG. 13 is a basic structural diagram of a circuit for controlling the delay of writing-data signals according to an embodiment.
FIG. 14 is a schematic diagram of each reference sub-signal in a writing-data signal according to an embodiment.
FIG. 15 is a schematic diagram of alignment of each reference sub-signal in a writing-data signal with a sampling edge of a sampling signal according to an embodiment.
FIG. 16 is a schematic diagram of a process of performing single-circuit offset adjustment training on each sub-circuit according to an embodiment.
FIG. 17 is a schematic structural diagram of each sub-circuit in a circuit for controlling the delay of writing-data signals according to an embodiment.
FIG. 18 is a basic structural diagram of a training circuit for writing-data signal delay control according to an embodiment.
FIG. 19 is a schematic flowchart of a method for controlling delay of writing-data signals according to another embodiment.
FIG. 20 is a structural block diagram of a apparatus for controlling delay of writing-data signals according to an embodiment.
FIG. 21 is an internal structure diagram of a computer device according to an embodiment.
FIG. 22 is an internal structure diagram of a computer device according to another embodiment.

### DESCRIPTION OF EMBODIMENTS

To make objectives, technical solutions, and advantages of this application clearer, this application is further described in detail below with reference to accompanying drawings and embodiments. It is to be understood that, the specific embodiments described herein are merely intended to explain this application, but are not intended to limit this application.

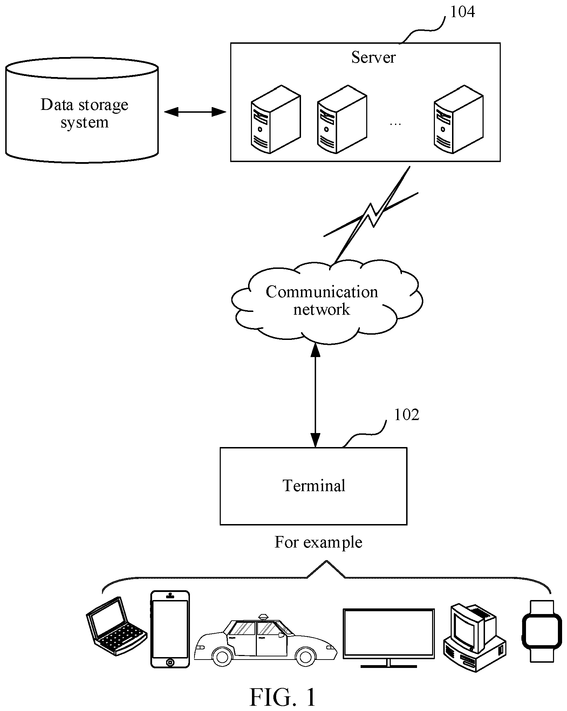

A method for controlling delay of writing-data signals (i.e., signals comprising data which is to be written into a memory) provided in this application may be applied to an application environment shown in FIG. 1. A terminal 102 communicates with a server 104 through a network. A data storage system may store data to be processed by the server 104. The data storage system may be integrated on the server 104, or may be arranged on the cloud or another server. The terminal 102 may be, but is not limited to, various desktop computers, notebook computers, smartphones, tablet computers, Internet of Things devices, and portable wearable devices. The Internet of Thing devices may be a smart speaker, a smart television, a smart air conditioner, a smart onboard device, and the like. The portable wearable device may be a smartwatch, a smart bracelet, a head-mounted device, and the like. The server 104 may be an independent physical server, or may be a server cluster formed by a plurality of physical servers or a distributed system, and may further be a cloud server providing basic cloud computing services such as cloud service, a cloud database, cloud computing, a cloud function, cloud storage, a network service, cloud communication, a middleware service, a domain name service, a security service, a CDN, and a big data and artificial intelligence platform. The terminal 102 and the server 104 may be directly or indirectly connected through wired or wireless communication, which is not limited in this application.

A high-bandwidth memory system including a host and a memory is deployed in the server 104. The server 104 may configure an operating mode of a register circuit in a memory by using the host, to obtain a training register that is readable and writable. The server 104 transmits a reference writing-data signal to the memory by using the host, samples the reference writing-data signal with a sampling signal (i.e., determines a sampled reference writing-data signal to be a series of values of the reference writing-data signal which are at times instances of falling/rising edges of the sampling signal) by using the memory, and caches a sampled writing-data signal obtained from the sampling into the training register. In a case that the sampled writing-data signal read by the host from the training register is inconsistent with (e.g., different in a sequence of values) the reference writing-data signal, the server 104 may perform offset adjustment training on a circuit for controlling the delay of writing-data signals arranged on the host based on the reference writing-data signal, to obtain a trained circuit. The server 104 may perform signal offset adjustment on an inputted writing-data signal by using the trained circuit, to obtain a target writing-data signal aligned with a sampling edge of the sampling signal. The target writing-data signal is to be written to the memory.

It may be understood that the host in the server 104 may generate a reference writing-data signal and transmit the reference writing-data signal to the memory in the server 104, to perform subsequent offset adjustment training. It may further be understood that the terminal 102 may alternatively generate a reference writing-data signal and transmit the reference writing-data signal to the server 104. Then the server 104 may receive the reference writing-data signal by using the host, and transmit the received reference writing-data signal to the memory in the server 104, to perform subsequent offset adjustment training. This is not limited in this embodiment. It may be understood that, the application scenario in FIG. 1 is merely a schematic illustration, and is not limited thereto.

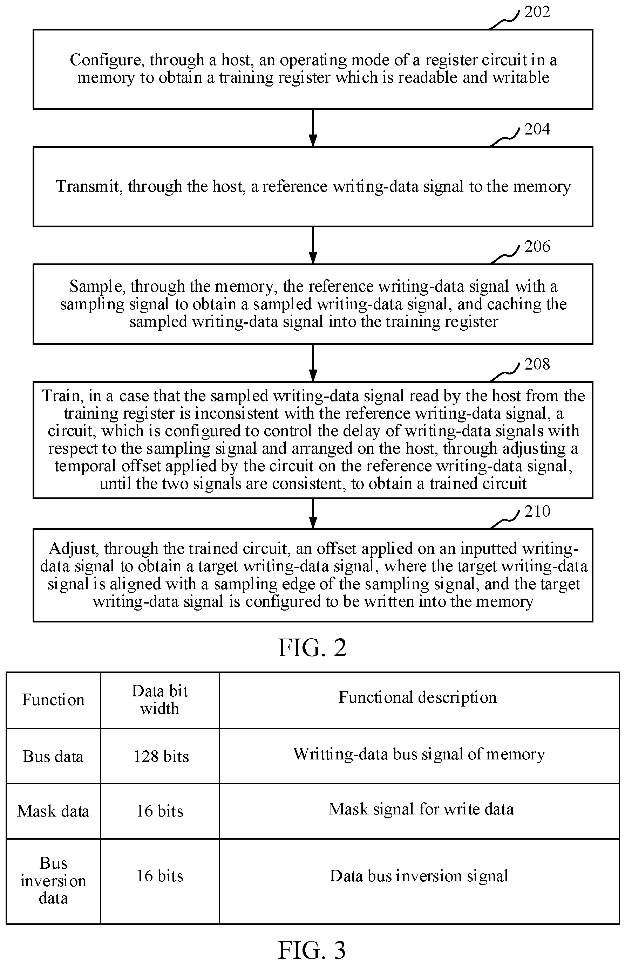

In embodiments of the present disclosure including the embodiments of both the claims and the specification (hereinafter referred to as "all embodiments of the present disclosure"), as shown in FIG. 2, a method for controlling delay of writing-data signals is provided. The method may be applied to a computer device. The computer device may be a terminal or a server. The method may be performed by the terminal or the server independently, or may be implemented through interaction between the terminal and the server. This embodiment is described by using an example in which the method is applied to the computer device, including the following steps:

Step 202: Configure, through a host, an operating mode of a register circuit in a memory to obtain a training register which is readable and writable.

The register circuit is an independent circuit in the memory, which can be configured in a plurality of operating modes. For example, the register circuit can be configured in a read-write mode, a read-only mode, a write-only mode, and the like. It may be understood that the register circuit is configured in the read-write mode, a register that is readable and writable may be obtained, that is, the training register is readable and writable. It may be understood that the training register is a register configured to cache data in a training stage. The register circuit is configured in the read-only mode, so that a register that is readable may be obtained. The register circuit is configured in the write-only mode, so that a register that is writable may be obtained.

Specifically, the computer device includes a host and a memory. The computer device may configure the operating mode of the register circuit in the memory by using the host, to obtain the training register that is readable and writable. It may be understood that the computer device may configure the operating mode of the register circuit in the memory in the read-write mode by using the host, to obtain the training register that is readable and writable.

In all embodiments of the present disclosure, the host and the memory may be components of a high-bandwidth memory system. The high-bandwidth memory system is deployed in the computer device.

In all embodiments of the present disclosure, the memory may be a dynamic random access memory (DRAM), or may be a RAM. This embodiment of this application is merely for illustration, and does not constitute a specific limitation on a type of the memory.

Step 204, through the host, a reference writing-data signal to the memory.

The reference writing-data signal is a writing-data signal used for training the circuit for controlling the delay of writing-data signals with respect to the sampling signal, which is arranged on the host, in the training stage. It may be understood that the reference writing-data signal is reference data used for training the circuit for controlling the delay of writing-data signals. The circuit for controlling the delay of writing-data signals is a circuit configured to controlling a delay on the writing-data signal to control alignment between the writing-data signal and the sampling edge of the sampling signal of the memory, so that the memory may correctly sample the writing-data signal with the sampling signal. The sampling signal is a clock signal for sampling, in the memory, the writing-data signal transmitted by the host.

Specifically, the computer device may obtain the reference writing-data signal by using the host, and transmit the reference writing-data signal to the memory by using the host.

In all embodiments of the present disclosure, as shown in FIG. 3, the writing-data signal may include three parts: a writing-data bus signal, a mask signal, and a data bus inversion signal. A data bit width of the writing-data bus signal is 128 bits, a data bit width of the mask signal is 16 bits, and a data bit width of the data bus inversion signal is 16 bits.

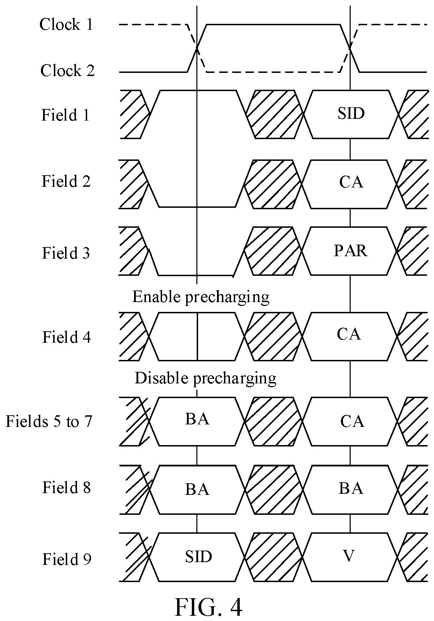

In all embodiments of the present disclosure, before the computer device transmits the reference writing-data signal to the memory by using the host, the host may first transmit a write instruction to the memory. The transmission of the write instruction needs to follow the timing shown in FIG. 4. It may be learned from FIG. 4 that the write instruction includes 9 fields, where an SID represents a stack identification number, a CA field represents a column address, a BA field represents a Bank address, a PAR field represents an instruction check field, and a V field may represent 1 or 0, that is, a high level or a low level. Clock 1 and clock 2 are two differential clocks.

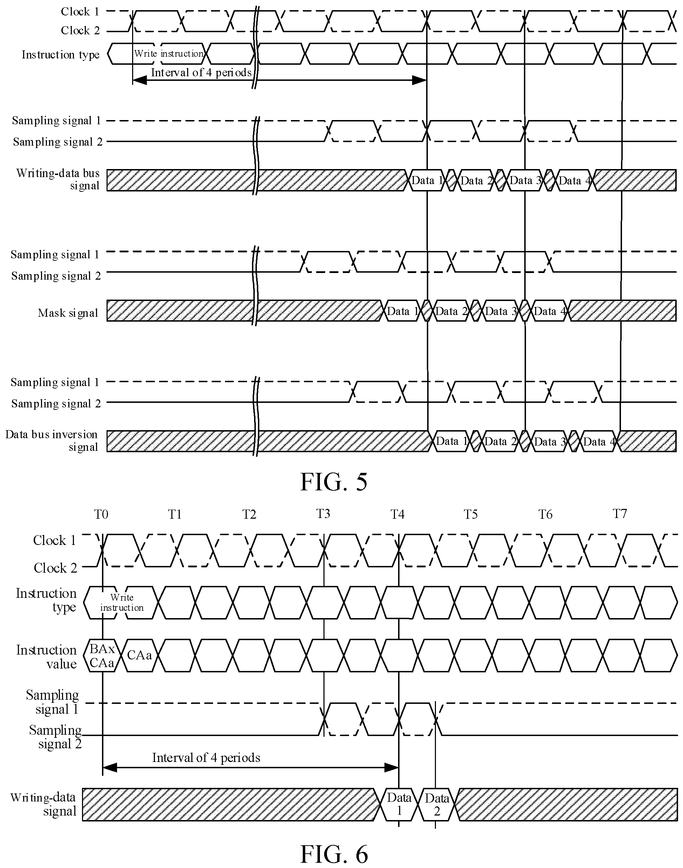

In all embodiments of the present disclosure, as shown in FIG. 5, the writing-data signal may include three parts: a writing-data bus signal, a mask signal, and a data bus inversion signal. The computer device further transmits the writing-data signal, that is, the writing-data bus signal, the mask signal, and the data bus inversion signal, to the memory by using the host at an interval of 4 periods after transmitting the write instruction to the memory by using the host. Each part in the writing-data signal corresponds to a respective sampling signal. Each part of the writing-data signal may include a plurality of sets of data (for example, 4 sets, that is, data 1, data 2, data 3, and data 4).

In all embodiments of the present disclosure, that the computer transmits the writing-data signal to the memory by using the host is implemented based on a burst form. To be specific, every time the writing-data signal is transmitted, a plurality of sets of writing-data signals are transmitted together. As shown in FIG. 6, a burst length of the writing-data signal transmitted by the computer to the memory by using the host is 2. The computer device may transmit the write instruction to the memory at a moment TO by using the host. After 4 periods of transmission of the write instruction, that is, at a moment T4, the computer device may transmit 2 sets of writing-data signals (that is, the data 1 and the data 2) to the memory by using the host. Values of the write instruction transmitted by the host to the memory include BAx (a Bank address) and CAa (a column address).

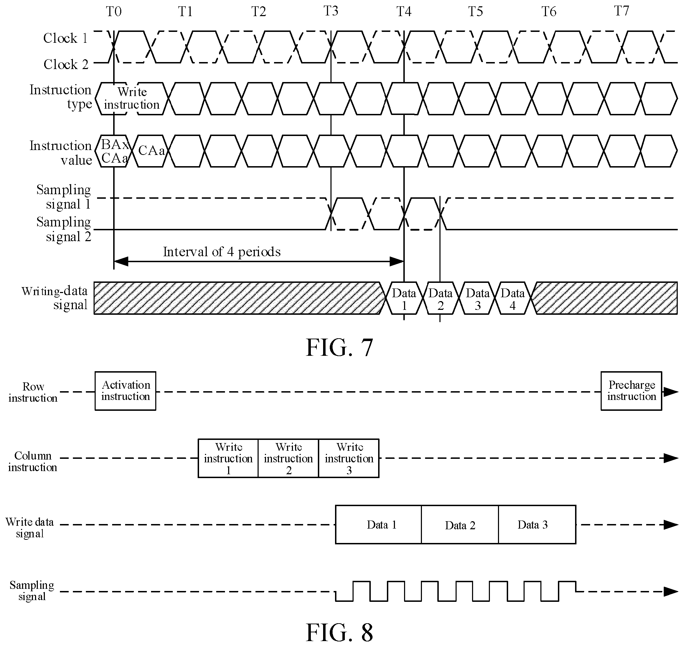

In all embodiments of the present disclosure, as shown in FIG. 7, a burst length of the writing-data signal transmitted by the computer to the memory by using the host may be 4. The computer device may transmit the write instruction to the memory at a moment TO by using the host. After 4 periods of transmission of the write instruction, that is, at a moment T4, the computer device may transmit 4 sets of writing-data signals (that is, the data 1, the data 2, the data 3, and the data 4) to the memory by using the host. Numerical values of the write instruction transmitted by the host to the memory include BAx (a Bank address) and CAa (a column address).

In all embodiments of the present disclosure, as shown in FIG. 8, the computer device may transmit an activation instruction to the memory by using the host to start current data writing. The computer device may transmit write instructions (that is, a write instruction 1, a write instruction 2, and a write instruction 3) to the memory by using the host after transmitting the activation instruction. Then the computer device may transmit writing-data signals (that is, data 1, data 2, and data 3) to the memory by using the host. During transmission of the writing-data signal, the host may also transmit a pulse signal for selecting writing data, which matches the writing-data signal and serves as the sampling signal, to the memory. Finally, the computer device may transmit a precharging instruction to the memory by using the host to end the current data writing.

Step 206: Sample, through the memory, the reference writing-data signal with a sampling signal to obtain a sampled writing-data signal, and cache the sampled writing-data signal into the training register.

The sampled writing-data signal is a new writing-data signal obtained by the memory with the sampling signal.

Specifically, the computer device also transmits the corresponding sampling signal to the memory while transmitting the reference writing-data signal to the memory by using the host. Then the computer device may sample the reference writing-data signal based on the received sampling signal by using the memory, and cache a sampled writing-data signal obtained from the sampling into the training register.

In all embodiments of the present disclosure, the computer device may transmit, by using the host, the reference writing-data signal to the memory along with the pulse signal for selecting writing data matching the reference writing-data signal. The memory may use the received pulse signal for selecting writing data as the sampling signal, and sample, with the sampling signal, the reference writing-data signal transmitted by the host, to obtain the sampled writing-data signal. It may be understood that since the sampling signal is the pulse signal for selecting writing data, which matches the reference writing-data signal, sampling accuracy of the writing-data signal may be improved by sampling the reference writing-data signal with the sampling signal.

Step 208: Train, in a case that the sampled writing-data signal read by the host from the training register is inconsistent with the reference writing-data signal, a circuit, which is configured to control the delay of writing-data signals with respect to the sampling signal, arranged on the host through adjusting a temporal offset applied by the circuit on the reference writing-data signal, until the sampled writing-data signal read by the host from the training register is consistent with the reference writing-data signal, to obtain a trained circuit.

Specifically, the computer device may read the sampled writing-data signal from the training register of the memory by using the host, and compare the sampled writing-data signal read by the host from the training register with the reference writing-data signal transmitted by the host to the memory. If the sampled writing-data signal is inconsistent with the reference writing-data signal, it means that a temporal offset exists between the reference writing-data signal, the sampling edge of the sampling signal during the transmission and the reference writing-data signal is not correctly sampled by the sampling signal, and hence the reference writing-data signal is not successfully cached to the training register. In this case, to ensure that a subsequent writing-data signal is aligned with the sampling edge of the sampling signal, the computer device may train the circuit for controlling the delay of writing-data signals arranged on the host through adjusting a temporal offset applied by the circuit on the reference writing-data signal, to obtain the trained circuit.

It can be understood that the writing-data signal is aligned with the sampling edge of the sampling signal, which specifically means that a temporal center of the writing-data signal is aligned with the sampling edge of the sampling signal of the memory.

In all embodiments of the present disclosure, the sampling edge of the sampling signal may include a rising edge of the sampling signal and a falling edge of the sampling signal. If the computer device samples the writing-data signal through the rising edge of the sampling signal of the memory, the temporal center of the writing-data signal is aligned with the rising edge of the sampling signal of the memory. If the computer device samples the writing-data signal through the falling edge of the sampling signal of the memory, the temporal center of the writing-data signal is aligned with the falling edge of the sampling signal of the memory. It may be understood that, since the sampling edge of the sampling signal includes the rising edge and the falling edge, determining at a finer granularity whether the rising edge of the sampling signal or the falling edge of the sampling signal is used to sample the writing-data signal can avoid misalignment, thereby further improving accuracy of sampling the writing-data signal.

In all embodiments of the present disclosure, the reference writing-data signal may include a plurality of reference sub-signals, and the circuit for controlling the delay of writing-data signals arranged on the host includes a plurality of sub-circuits. Each sub-circuit is configured to control a delay of a respective one of the reference sub-signals. The computer device may train the plurality of sub-circuits through adjusting the temporal offset applied by the circuit on the plurality of reference sub-signals, to obtain a trained circuit.

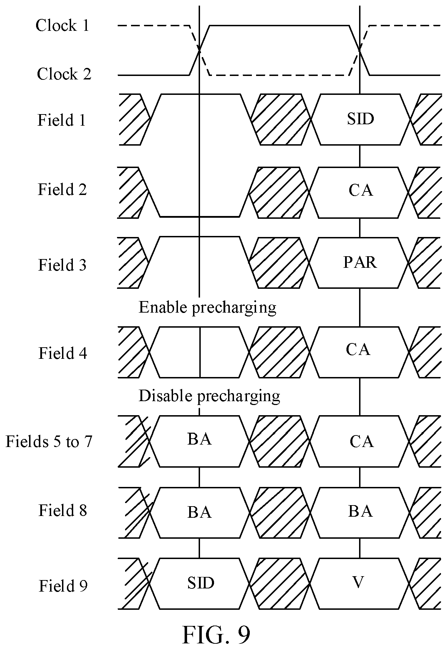

In all embodiments of the present disclosure, before the computer device may read the sampled writing-data signal from the training register of the memory by using the host, the host first transmits a read instruction to the memory. The transmission of the read instruction needs to follow the timing shown in FIG. 9. As shown in FIG. 9, the read instruction includes 9 fields, where an SID represents a stack identification number, a CA field represents a column address, a BA field represents a Bank address, a PAR field represents an instruction check field, and a V field may represent 1 or 0, that is, a high level or a low level.

Step 210: Adjust, through the trained circuit, a temporal offset applied on an inputted writing-data signal to obtain a target writing-data signal, where the target writing-data signal is aligned with a sampling edge of the sampling signal, and the target writing-data signal is configured to be written into the memory.

The inputted writing-data signal is a writing-data signal obtained by the host in actual application after the training stage. The target writing-data signal is a writing-data signal on which its temporal offset has been adjust and which has been aligned with the sampling edge of the sampling signal.

Specifically, in actual application stage after the training, the computer device may obtain the writing-data signal in actual application by using the host, and input the obtained writing-data signal into the trained circuit, so as to adjust the temporal offset applied on the inputted writing-data signal by using the trained circuit, and thereby obtain the target writing-data signal that is aligned with the sampling edge of the sampling signal in the memory. Then the computer device may transmit the target writing-data signal, which has been adjusted, to the memory, and the memory may sample the target writing-data signal with the sampling signal and write the sampled target writing-data signal to the memory.

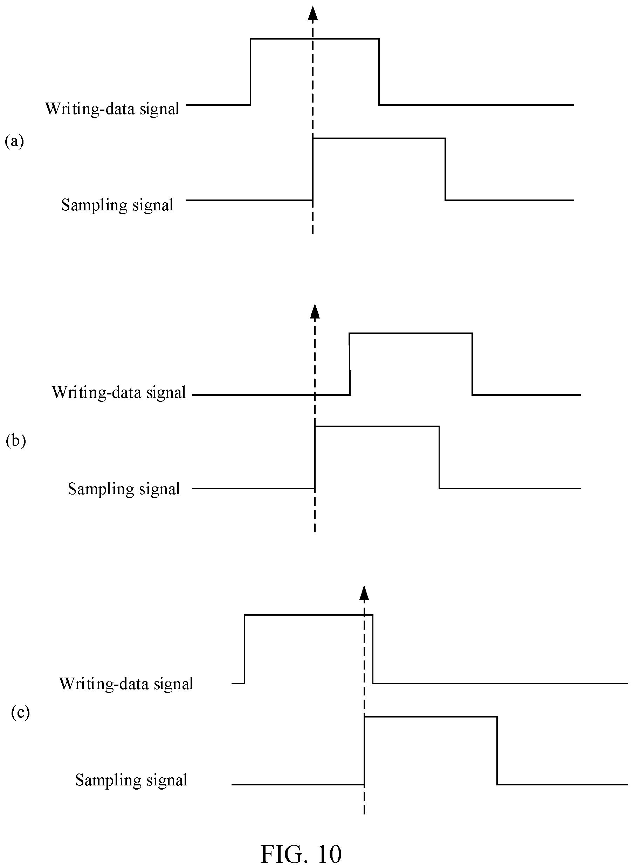

In all embodiments of the present disclosure, the computer device may sample the writing-data signal by using the rising edge of the sampling signal of the memory. As shown in FIG. 10, a center of the writing-data signal in (a) is exactly aligned with the rising edge of the sampling signal. In this case, the memory may accurately sample the writing-data signal with the sampling signal. An temporal offset exists between a center of the writing-data signal in (b) and the rising edge of the sampling signal, and the rising edge of the sampling signal has even drifted out of a data window of the writing-data signal. In this case, the memory cannot sample the writing-data signal correctly with the sampling signal. An temporal offset also exists between a center of the writing-data signal in (c) and the rising edge of the sampling signal. In this case, the memory cannot sample the writing-data signal correctly with the sampling signal.

In the foregoing method for controlling delay of writing-data signals, the operating mode of the register circuit in a memory configured through the host to obtain the training register which is readable and writable. The reference writing-data signal is transmitted through the host to the memory. The reference writing-data signal is sampled through the memory with the sampling signal with the sampling signal to obtain the sampled writing-data signal, and the sampled writing-data signal is cached into the training register. The sampled writing-data signal is compared with the reference writing-data signal transmitted from the host. The sampled writing-data signal read by the host from the training register being inconsistent with the reference writing-data signal indicates that there is a temporal offset between the reference writing-data signal transmitted from the host and the sampling signal of the memory. In such case, the circuit for controlling the delay of writing-data signals, which is arranged on the host, may be trained through adjusting the temporal offset applied by the circuit on the reference writing-data signal based on the reference writing-data signal, so as to obtain the trained circuit. In an actual operation, the temporal offset applied on the inputted writing-data signal may be adjusted through the trained circuit, and the target writing-data signal is configured to be written into the memory. Thereby, the target writing-data signal received by the memory can be aligned with the sampling edge of the sampling signal, so that the memory can correctly sample the writing-data signal transmitted from the host. Correctness of data written into the memory is ensured, and operation stability of the memory is improved.

In all embodiments of the present disclosure, configuring, through the host, the operating mode of the register circuit in the memory may include: setting, through the host, a value of a mode register in the memory to be a target value, where the operating mode of the register circuit is capable to be configured through the mode register, and the target value indicates that the register circuit is readable and writable. The operating mode of the register circuit is controlled to be a read-write mode under the target value to obtain the training register.

Specifically, the mode register is deployed in the memory. The mode register may be used for configuring the operating mode of the register circuit in the memory. It may be understood that the computer device may set a value of the mode register in the memory to the target value corresponding to the read-write mode by using the host, and then the register circuit can be controlled to operate in the read-write mode under the target value. When serving as the training register that is readable and writable, the register circuit operates in the read-write mode.

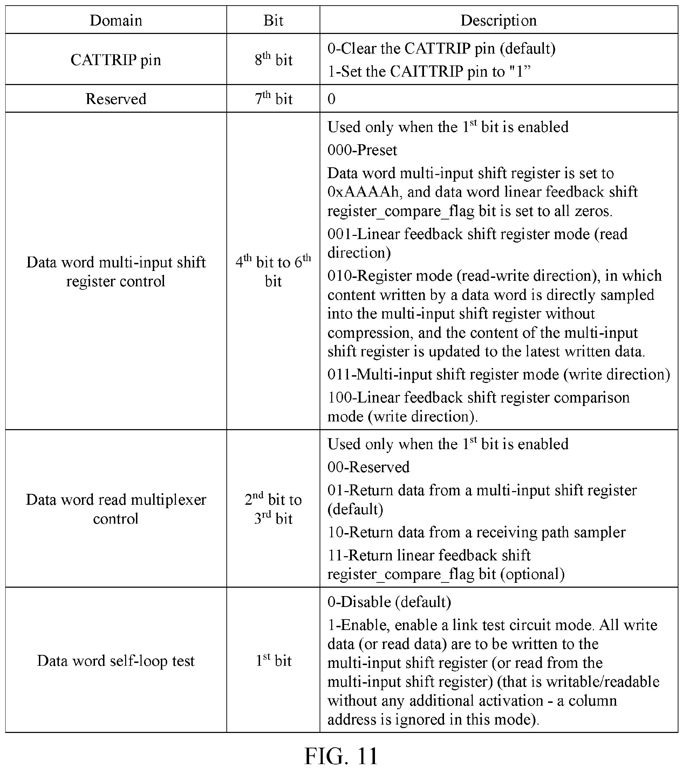

In all embodiments of the present disclosure, configuration of the operating mode of the mode register may be described as shown in FIG. 11. The value of the mode register includes 8 bits of data. The 1^{st} bit is configured for a data word self-loop test, the 2^{nd} bit and the 3^{rd} bit are configured for data word read multiplexer control, the 4^{th} bit to the 6^{th} bit are configured for data word multi-input shift register control, the 7^{th} bit is a reserved bit, and the 8^{th} bit is configured for a CATTRIP pin of the memory. For example, the mode register is configured to an 8-bit binary value, that is, 00000001, and a default value in the register circuit may be reset to a hexadecimal value, that is, 0xAAAAAh. The mode register is configured to an 8-bit binary value, that is, 00010011, and the operating mode of the register circuit may be configured as the register mode (a read-write direction), that is, a read-write mode, to obtain the training register. It may be understood that if the host writes new data to the memory, the newly written data may overwrite an original default value of 0xAAAAAh.

In the foregoing embodiments, since the mode register in the memory may be used for configuring the operating mode of the register circuit, configuration efficiency and configuration accuracy of the register circuit can be improved by setting the value of the mode register in the memory to configure the operating mode of the register circuit.

In all embodiments of the present disclosure, the reference writing-data signal may include a plurality of reference sub-signals. The circuit for controlling the delay of writing-data signals arranged on the host includes a plurality of sub-circuits. Each sub-circuit is configured to control a delay of a respective reference sub-signal. Training the circuit through adjusting the temporal offset applied by the circuit on the reference writing-data signal includes: training each sub-circuit through adjusting a temporal offset applied by said sub-circuit on the respective reference sub-signal to obtain an initial sub-circuit, where the respective reference sub-signal is aligned with a respective sampling edge of the sampling signal after the initial sub-circuit applies the adjusted temporal offset on the respective reference sub-signal; and training a plurality of initial sub-circuits through adjusting temporal offsets applied by the plurality of initial sub-circuits on the plurality of reference sub-signals to obtain the trained circuit, where the trained circuit includes a plurality of target sub-circuits, and each reference sub-signal is aligned with a same sampling edge of the sampling signal after a respective target sub-circuit applies the adjusted temporal offset on said respective reference sub-signal.

The initial sub-circuit is an initially trained circuit obtained by adjusting a temporal offset applied by one sub-circuit on the respective reference sub-signal. The target sub-circuit is a eventually trained circuit obtained by further adjusting temporal offsets applied by the plurality of initial sub-circuits on the plurality of reference sub-signals.

Specifically, the computer device may train each sub-circuit in the circuit for controlling the delay of writing-data signals through adjusting the temporal offset applied by the sub-circuit based on the reference sub-signal corresponding to the sub-circuit, so as to obtain the initial sub-circuit. It may be understood that if the computer device inputs the reference sub-signal into the initial sub-circuit, the reference sub-signal subject to the adjusted temporal offset applied by the initial sub-circuit is aligned with the sampling edge of the sampling signal. The computer device may train a plurality of the initial sub-circuits through adjusting the temporal offsets applied by the plurality of initial sub-circuits plurality applied on the plurality of reference sub-signals, so as to obtain a plurality of target sub-circuits, and determine the plurality of target sub-circuits to serve as the trained circuit. It may be understood that if the computer device inputs the reference sub-signals into the target sub-circuits, all reference sub-signals subject to the adjusted temporal offsets applied by the respective target sub-circuits are aligned with the same sampling edge of the sampling signal.

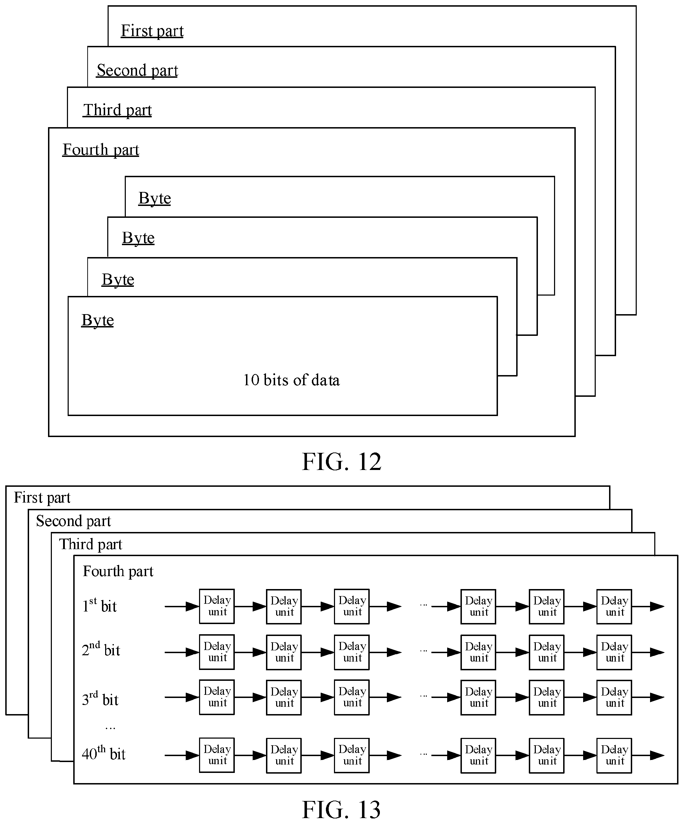

In all embodiments of the present disclosure, as shown in FIG. 12, the reference writing-data signal may include 160 reference sub-signals. It may be understood that the reference writing-data signal includes 160 bits of reference sub-signals. The 160 bits of the reference writing-data signal may be divided into four parts: a first part, a second part, a third part, and a fourth part. Each part includes four byte spaces, and each byte space includes 10 bits of data. In other words, each part includes 40 bits of data. It may be understood that the reference writing-data signal consists of 128 bits of writing-data bus signals, 16 bits of mask signals, and 16 bits of data bus inversion signals.

In all embodiments of the present disclosure, as shown in FIG. 13, the 160 bits of the reference writing-data signal may be divided into four parts: a first part, a second part, a third part, and a fourth part. Each part includes 40 bits of reference sub-signals. The circuit for controlling the delay of writing-data signals arranged on the host includes 160 sub-circuits. One sub-circuit includes a plurality of write data delay control units, and the sub-circuit is configured to control delay of one reference sub-signal.

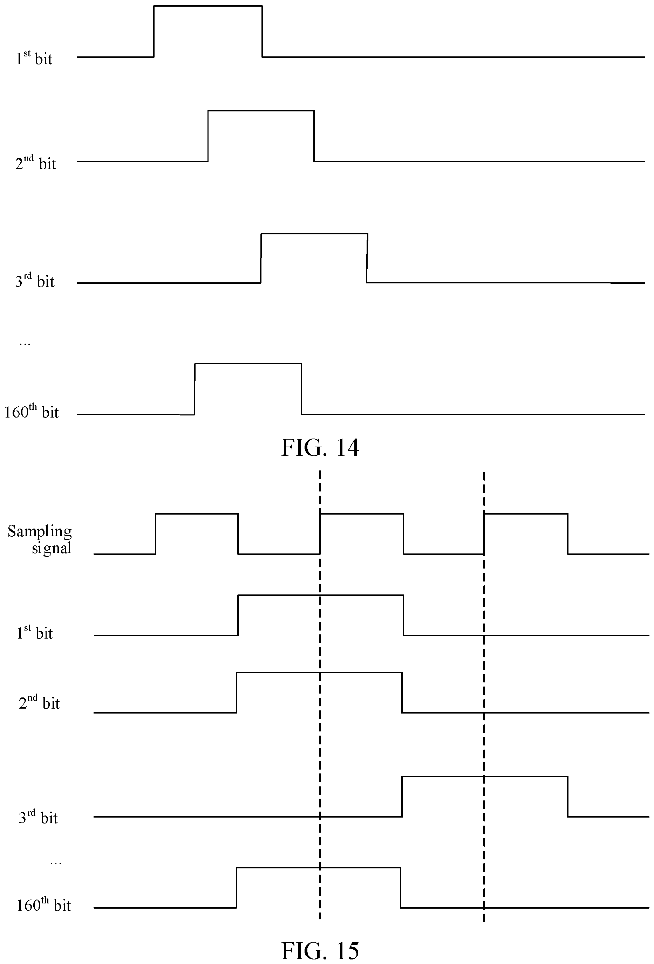

In all embodiments of the present disclosure, as shown in FIG. 14, the reference writing-data signal may include 160 bits of reference sub-signals, and the circuit for controlling the delay of writing-data signals includes 160 sub-circuits, one sub-circuit being configured to control a delay of one reference sub-signal. For each of the 160 sub-circuits, the sub-circuit is independently trained through adjusting the temporal offset it applied on its corresponding reference sub-signal, so as to obtain the initial sub-circuit, and the reference sub-signal subject to the adjusted temporal offset applied by the trained initial sub-circuit is aligned with the sampling edge of the sampling signal. It may be understood that the reference sub-signals, having the 160 bits and subject to the adjusted temporal offset applied by the trained initial sub-circuits, each is only aligned with a respective sampling edge of the sampling signal, but not necessarily aligned with the same sampling edge of the sampling signal. As shown in FIG. 15, the reference sub-signals having the 160 bits are not aligned with the same sampling edge of the sampling signal. In this case, more training is required, and all sub-circuits shall be further trained until the reference sub-signals having the160 bits are aligned with the same sampling edge of the sampling signal, so as to obtain the trained circuit.

In the foregoing embodiments, the single-circuit offset adjustment training is first performed on each sub-circuit in the circuit for controlling the delay of writing-data signals to obtain an initial sub-circuit, so that each reference sub-signal in the reference writing-data signal is aligned with the respective sampling edge of the sampling signal. Since the sampling edges of the sampling signals aligned with the reference sub-signals are not necessarily the same sampling edge, to ensure that the sampling edges of the sampling signals aligned with the reference sub-signals are the same sampling edge, multi-circuit offset adjustment training may be further performed on the initial sub-circuits obtained through the single-circuit offset adjustment training, so that the sampling edges of the sampling signals aligned with the reference sub-signals are the same sampling edge, thereby improving a training effect on the circuit for controlling the delay of writing-data signals.

In all embodiments of the present disclosure, the sampled writing-data signal may include a plurality of sampled sub-signals, and each sampled sub-signal is obtained through sampling a respective reference sub-signal of the plurality of reference sub-signals. Training the plurality of initial sub-circuits through adjusting the temporal offsets applied by the plurality of initial sub-circuits on the plurality of reference sub-signals includes, in a case that the host is incapable to read the plurality of sampled sub-signals entirely from the training register after one iteration of training: keeping training one or more intermediate sub-circuits based on initial adjustment information of the one or more intermediate sub-circuits until the host is capable to read the plurality of sampled sub-signals entirely from the training register after one iteration of training, where the one or more intermediate sub-circuit are among the plurality of initial sub-circuits, the respective sampled sub-signal of each intermediate sub-circuit is not capable to be read by the host, and the initial adjustment information of each intermediate sub-circuit is obtained from training the respective sub-circuit to obtain the respective initial sub-circuit.

Specifically, the computer device may use the initial sub-circuit corresponding to an incapable-to-read reference sub-signal as the intermediate sub-circuit. In addition, the computer device may determine adjustment information obtained during the single-circuit offset adjustment training, which has been performed in obtaining the initial sub-circuit, as the initial adjustment information of the intermediate sub-circuit. The computer device may try to read each sampled sub-signal from the training register of the memory by using the host. If the host cannot read the plurality of sampled sub-signals entirely from the training register after one iteration of the training, it means that the sampling edges, of the sampling signal, with which the reference sub-signals are currently aligned are not the same sampling edge. In this case, the computer device may continuously perform the next iteration of the training on the intermediate sub-circuit(s) based on the initial adjustment information of the intermediate sub-circuit(s), until the host can read the plurality of sampled sub-signals entirely from the training register after one iteration. It can be understood that the host being capable to read the plurality of sampled sub-signals entirely from the training register after one iteration means that the sampling edges, of the sampling signal, with which the reference sub-signals are currently aligned are the same sampling edge. In this case, the trained circuit can be determined as the plurality of target sub-circuits obtained from the continuous training.

In the foregoing embodiments, the host being incapable to read the plurality of sampled sub-signals entirely from the training register after one iteration indicates that the sampling edges, of the sampling signal, with which the reference sub-signals are current aligned are not the same sampling edge. In this case, the offset adjustment training is further performed on the intermediate sub-circuit(s) based on the initial adjustment information of the intermediate sub-circuit(s), until the host is capable to read the plurality of sampled sub-signals from the training register at one time, so that the reference sub-signals are aligned with the same sampling edge of the sampling signal, thereby further improving the training effect on the circuit for controlling the delay of writing-data signals.

In all embodiments of the present disclosure, keeping training the one or more intermediate sub-circuits based on the initial adjustment information of the one or more intermediate sub-circuits until the host is capable to read the plurality of sampled sub-signals entirely from the training register after one iteration of training may include: increasing or decreasing the temporal offset, which is applied on a target reference sub-signal, gradually based on the initial adjustment information of an intermediate sub-circuit of the one or more intermediate sub-circuits, until the host is capable to read the plurality of sampled sub-signals entirely from the training register after one iteration of training, where the target reference sub-signal is the respective reference sub-signal of the intermediate sub-circuit.

Specifically, the computer device may use the intermediate reference sub-signal corresponding to the sub-circuit as the target reference sub-signal. Then the computer device may gradually adjust, based on the initial adjustment information of the intermediate sub-circuit(s), the intermediate sub-circuit(s) through increasing or decreasing the temporal offset(s) applied on the target reference sub-signal(s), until the host is capable to read the plurality of sampled sub-signals entirely from the training register after one iteration, so as to obtain the trained circuit.

It may be understood that the intermediate sub-circuit is adjusted based on the initial adjustment information, so that the target reference sub-signal may be moved backward or forward in clock periods with the purpose of increasing or decreasing the temporal offset.

For example, the computer device may first adjust, based on the initial adjustment information of an intermediate sub-circuit, the intermediate sub-circuit through increasing the temporal offset applied on the target reference sub-signal by one clock period. If the host still cannot read the plurality of sampled sub-signals entirely from the training register after one iteration, the target reference sub-signal is restored to a state before the adjustment, and then the intermediate sub-circuit is adjusted through decreasing the temporal offset applied on the target reference sub-signal by one clock period. If the host still cannot read the plurality of sampled sub-signals entirely from the training register after another iteration, the intermediate sub-circuit is further adjusted through increasing the temporal offset applied on the target reference sub-signal by two clock periods. If the host still cannot read the plurality of sampled sub-signals entirely from the training register after yet another iteration, the intermediate sub-circuit is further adjusted through decreasing the temporal offset applied on the target reference sub-signal by two clock periods. Further adjustment may be deduced by analogy. The intermediate sub-circuit is gradually adjusted as above until the host is capable to read the plurality of sampled sub-signals entirely from the training register after certain iteration, so as to obtain the trained circuit.

In the foregoing embodiments, in a case that the host cannot read the plurality of sampled sub-signals entirely from the training register after one iteration, the intermediate sub-circuit is gradually adjusted based on the initial adjustment information of the intermediate sub-circuit through increasing or decreasing the temporal offset applied on the target reference sub-signal, until the host is capable to read the plurality of sampled sub-signals entirely from the training register after one iteration, so that the reference sub-signals are aligned with the same sampling edge of the sampling signals, thereby further improving the training effect on the circuit for controlling the delay of writing-data signals.

In all embodiments of the present disclosure, the foregoing method for controlling delay of writing-data signals may further include: determining the plurality of initial sub-circuits as the plurality of target sub-circuits, in a case that the host is capable to read the plurality of sampled sub-signals entirely from the training register after one iteration of training.

Specifically, the computer device may try to read each sampled sub-signal from the training register of the memory by using the host. If the host is capable to read the plurality of sampled sub-signals entirely from the training register after one generation, it means that the sampling edges, of the sampling signal, with which the reference sub-signals are aligned with are the same sampling edge. In this case, each initial sub-circuit serve as the respective target sub-circuit, so as to obtain the trained circuit.

In the foregoing embodiments, if the host is capable to read the plurality of sampled sub-signals entirely from the training register after one iteration, it means that the sampling edges with which the reference sub-signals are aligned are the same sampling edge. In this case, each initial sub-circuit may be directly used as the respective target sub-circuit, so as to obtain the trained circuit. In this way, the training efficiency of the circuit for controlling the delay of writing-data signals can be enhanced while ensuring the training effect on the circuit for controlling the delay of writing-data signals.

In all embodiments of the present disclosure, each sub-circuit may include delaying units that are successively connected, an output terminal of each of the delaying units is configured as a tap from which a signal is capable to be extracted from said sub-circuit, and a target tap is determined from the taps for the initial sub-circuit. Training each sub-circuit through adjusting the temporal offset applied by said sub-circuit on the respective reference sub-signal includes: training each sub-circuit through adjusting the temporal offset applied by said sub-circuit on the respective reference sub-signal to determine adjustment information for said sub-circuit; and determining the target tap from the taps in each sub-circuit based on the adjustment information, where each delaying unit in an upstream of the target tap is configured to apply the temporal offset on the respective reference sub-signal for said sub-circuit to achieve alignment with the respective sampling edge of the sampling signal.

The delaying unit is a smallest unit in the sub-circuit for performing delay control processing on the writing-data signal. It may be understood that a larger quantity of delaying units each controlling a respective delay (or an respective temporal offset) applied on the writing-data signal lead to a longer delay of the writing-data signal, and vice versa. The tap is an interface arranged as an output of each delaying unit in the sub-circuit, and the tap can be used for outputting a signal from the sub-circuit. It may be understood that the writing-data signal may be extracted from any tap when being transmitted through the sub-circuit, and thereby he writing-data signal is exported from the sub-circuit. It may be understood that the delaying unit(s) in the sub-circuit in an upstream, with respect to signal transmission, of the tap responsible for exporting the writing-data signal control the final temporal offset applied on the writing-data signal, and the delaying unit(s) in a downstream, with respect to signal transmission, of the tap does not control the final temporal offset applied on the writing-data signal. The adjustment information is information concerning adjustment on the sub-circuit. It may be understood that the adjustment on the sub-circuit refers to adjustment on a quantity of delaying units in the sub-circuit which the writing-data signal passes during its transmission, and the adjustment aims to decrease or increase the temporal offset applied on the writing-data signal. The target tap is a tap through which the writing-data signal is extracted from the sub-circuit. The target delaying unit(s) refers to all delaying units located in the upstream of the target tap in the sub-circuit.

Specifically, the computer device may perform the offset adjustment training on each sub-circuit, in the circuit for controlling the delay of writing-data signals, based on the reference sub-signal corresponding to the sub-circuit. After the training, the computer device may obtain the adjustment information for the sub-circuit through the host. The computer device may determine the target tap from all taps in the sub-circuit based on the adjustment information. It may be understood that the computer device may apply the temporal offset (or the delay) on the reference sub-signal corresponding to the sub-circuit by using the target delay unit(s) in the upstream of the target tap, so as to adjust a temporal offset between the reference sub-signal corresponding to the sub-circuit and the sampling edge of the sampling signal. Thereby, the reference sub-signal corresponding to the sub-circuit is aligned with the sampling edge of the sampling signal in the memory.

In all embodiments of the present disclosure, the computer device may perform offset adjustment training on the sub-circuit based on the reference sub-signal corresponding to the sub-circuit. To be specific, the computer device may adjust the sub-circuit through the host increasing the temporal offset applied on the reference sub-signal corresponding to the sub-circuit and/or decreasing the temporal offset applied on the reference sub-signal corresponding to the sub-circuit, so as to implement the offset adjustment training on the sub-circuit and thereby obtain the adjustment information.

In all embodiments of the present disclosure, the computer device may increase the temporal offset applied on the reference sub-signal corresponding to the sub-circuit by increasing the quantity of delaying units which the reference sub-signal corresponding to the sub-circuit passes during its transmission, and decrease the temporal offset applied on the reference sub-signal corresponding to the sub-circuit by decreasing the quantity of delaying units which the reference sub-signal corresponding to the sub-circuit passes during its transmission.

In the foregoing embodiments, the adjustment information of each sub-circuit may be determined through the single-circuit offset adjustment training on each corresponding sub-circuit based on the reference sub-signal corresponding to the sub-circuit. Therefore, the target tap may be determined from each sub-circuit based on the adjustment information corresponding to each sub-circuit, so as to obtain the initial sub-circuit, which improves the training effect of the initial sub-circuit.

In all embodiments of the present disclosure, training each sub-circuit through adjusting the temporal offset applied by said sub-circuit on the respective reference sub-signal to determine the adjustment information for said sub-circuit includes, for each sub-circuit, when said sub-circuit is in a first state under which the memory is capable to obtain a signal consistent with (e.g., identical in the sequence of values) the respective sub-signal through sampling the respective reference sub-signal with the sampling signal may include: adjusting the temporal offset to increase a delay of the respective reference sub-signal of said sub-circuit, until said sub-circuit enters a second state under which the memory is incapable to obtain the signal consistent with the respective sub-signal through sampling the respective reference sub-signal with the sampling signal, to obtain first adjustment information of said sub-circuit; restoring said sub-circuit from the second state to the previous first state; adjusting the temporal offset to decrease the delay of the respective reference sub-signal of said sub-circuit, until said sub-circuit enters the second state, to obtain second adjustment information of said sub-circuit; and determining the adjustment information for said sub-circuit based on the first adjustment information and the second adjustment information.

The first state is a state under which the memory is capable to obtain a signal consistent with the respective sub-signal through sampling the respective reference sub-signal with the sampling signal. The second state is a state in which the memory is incapable to obtain the signal consistent with the respective sub-signal through sampling the respective reference sub-signal with the sampling signal. The first adjustment information is the adjustment information concerning transition of the memory from being capable to obtain the signal consistent with the respective sub-signal through the sampling to being incapable to obtain the signal consistent with the respective sub-signal through the sampling, that is, concerning a critical state of sampling the reference sub-signal corresponding to the sub-circuit, during a process of increasing the temporal offset applied on the reference sub-signal corresponding to the sub-circuit. The second adjustment information is the adjustment information concerning transition of the memory from being capable to obtain the signal consistent with the respective sub-signal through the sampling to being incapable to obtain the signal consistent with the respective sub-signal through the sampling, that is, concerning a critical state of sampling the reference sub-signal corresponding to the sub-circuit, during a process of decreasing the temporal offset applied on the reference sub-signal corresponding to the sub-circuit.

Specifically, for each sub-circuit in the circuit for controlling the delay of writing-data signals, the computer device may transmit the reference sub-signal corresponding to the sub-circuit to the memory by using the host, and may sample the reference sub-signal corresponding to the sub-circuit with the sampling signal of the memory. In the first state under which the memory is capable to obtain the signal consistent with the respective sub-signal through sampling the respective reference sub-signal with the sampling signal, the computer device may adjust the sub-circuit through increasing the temporal offset applied on the reference sub-signal corresponding to the sub-circuit. To be specific, the quantity of delaying units which the reference sub-signal corresponding to the sub-circuit passes during it transmission is gradually increased, and the first adjustment information for the sub-circuit is recorded when entering the second state under which the memory is incapable to obtain the signal consistent with the respective sub-signal through sampling the respective reference sub-signal with the sampling signal. The second state is then restored to the previous first state. To be specific, the second state under which the memory is incapable to obtain the signal consistent with the respective sub-signal through sampling the respective reference sub-signal with the sampling signal is restored to the first state under which the memory is capable to obtain the signal consistent with the respective sub-signal through sampling in the earlier stage of the training. The sub-circuit is then adjusted through decreasing the temporal offset applied on the reference sub-signal corresponding to the sub-circuit. To be specific, the quantity of delaying units which the reference sub-signal corresponding to the sub-circuit passes during its transmission is gradually decreased, and the second adjustment information for the sub-circuit is recorded when entering the second state again. Then, the computer device may determine that the first adjustment information and the second adjustment information to serve as the adjustment information for said sub-circuit.

In all embodiments of the present disclosure, the computer device may gradually increase or decrease the quantity of delaying units which the reference sub-signal corresponding to the sub-circuit passes during its transmission. To be specific, the quantity of delaying units which the reference sub-signal corresponding to the sub-circuit passes during its transmission can be gradually increased or deduced, and a step size of adjusting the quantity of delaying units may be at least one. For example, one delaying unit serves as a step size of the increasing or decreasing, two delaying units serve as the step size of the increasing or decreasing, or three delaying units serve as the step size of the increasing or decreasing.

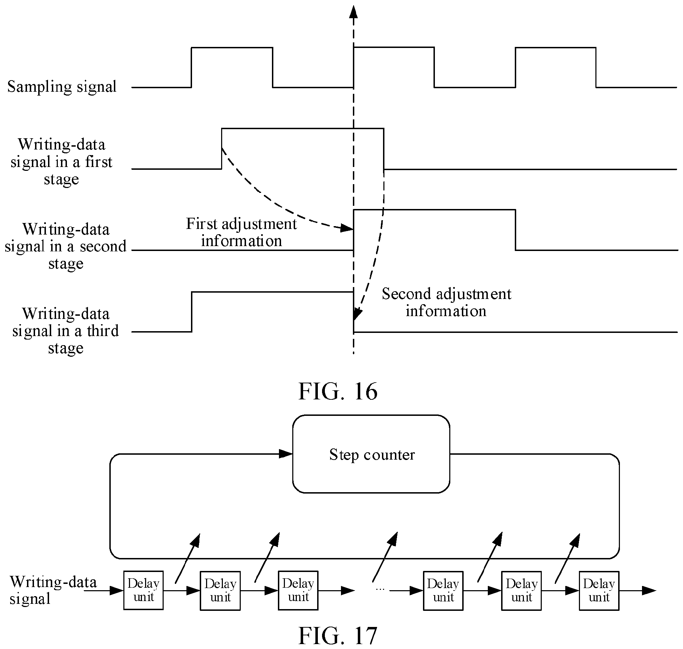

In all embodiments of the present disclosure, as shown in FIG. 16, the computer device may sample the reference sub-signal corresponding to the sub-circuit with the sampling signal of the memory. In a first stage of the offset adjustment training, there is the first state under which the memory is capable to obtain the signal consistent with the respective sub-signal through sampling the respective reference sub-signal with the sampling signal, the computer device may adjust the circuit for controlling the delay of writing-data signals on the host through increasing the temporal offset applied on the reference sub-signal corresponding to the sub-circuit, and immediately record the first adjustment information for the sub-circuit when entering the second state under which the memory is incapable to obtain the signal consistent with the respective sub-signal through sampling the respective reference sub-signal with the sampling signal, that is, when entering a second stage of the offset adjustment training. Then, the computer device may restore the second state to the previous first state, that is, restore from the second state back to the earlier first stage in the offset adjustment training, afterwards adjust the sub-circuit through decreasing the temporal offset applied on the reference sub-signal corresponding to the sub-circuit, and immediately record the second adjustment information for the sub-circuit when the second state again, that is, when entering a third stage of the offset adjustment training.

In the foregoing embodiments, the memory is capable to obtain the signal consistent with the respective sub-signal through sampling the respective reference sub-signal with the sampling signal, which indicates that at such time the sampling edge of the sampling signal is still located within a data window in the reference sub-signal. In this case, the sub-circuit is adjusted through increasing the temporal offset applied on the reference sub-signal corresponding to the sub-circuit, i.e., increasing the delay of the reference sub-signal. Once the signal consistent with the respective sub-signal cannot be obtained through sampling the respective reference sub-signal with the sampling signal, the first adjustment information indicating a critical state at one edge of the data window may be immediately recorded. Afterwards the reference sub-signal corresponding to the sub-circuit is reset, and the temporal offset applied on the reference sub-signal may be decreased through adjusting the sub-circuit to decrease the delay of the reference sub-signal corresponding to the sub-circuit. Once the signal consistent with the respective sub-signal cannot be obtained through sampling the respective reference sub-signal with the sampling signal, the second adjustment information indicating a critical state at the other edge of the data window may be immediately recorded. Since exact one clock period may be determined from the first adjustment information and the second adjustment information, the adjustment information for the sub-circuit can be accurately determined based on the first adjustment information and the second adjustment information.

In all embodiments of the present disclosure, each sub-circuit may include a first circuit and a second circuit, an input of the second circuit is connected with an output of the first circuit, the first circuit and the second circuit each includes a part of the delaying units that are successively connected, the first adjustment information includes a first quantity of the delaying units in the second circuit through which the respective reference sub-signal of said sub-circuit passes. When said sub-circuit is in the first state under which the memory is capable to obtain the signal consistent with the respective sub-signal through sampling the respective reference sub-signal with the sampling signal, adjusting the temporal offset to increase the delay of the respective reference sub-signal of said sub-circuit, until said sub-circuit enters the second state under which the memory is incapable to obtain the signal consistent with the respective sub-signal through sampling the respective reference sub-signal with the sampling signal includes: controlling the respective reference sub-signal to pass through the delaying units in the first circuit successively to obtain an intermediate reference sub-signal; and when said sub-circuit is in the first state under which the memory is capable to obtain the signal consistent with the respective sub-signal through sampling the respective reference sub-signal with the sampling signal, increasing a delay of the intermediate reference sub-signal through controlling the respective reference sub-signal to pass further through the delaying units in the second circuit successively, until said sub-circuit enters the second state, where the second state is that the memory is incapable to obtain the signal consistent with the respective sub-signal through sampling the respective reference sub-signal with the sampling signal from the tap of a last delaying unit through which the respective reference sub-signal passes; and recording the first quantity of the delaying units in the second circuit through which the respective reference sub-signal of said sub-circuit passes, when said sub-circuit enters the second state.

The first circuit and the second circuit are component circuits in the sub-circuit.

Specifically, for each sub-circuit in the circuit for controlling the delay of writing-data signals, the computer device may control, by using the host, the reference sub-signal corresponding to the sub-circuit to pass through the delaying unit(s) in the first circuit successively to apply an initial temporal offset on the reference sub-signal, and thereby obtain the intermediate reference sub-signal. The computer device may sample the intermediate reference sub-signal corresponding to the sub-circuit with the sampling signal in the memory. In case of the first state under which the memory is capable to obtain the signal consistent with the respective sub-signal through sampling the respective reference sub-signal with the sampling signal, the computer device may further control the intermediate reference sub-signal corresponding to the sub-circuit to pass through the delaying unit(s) in the second circuit successively to increase the temporal offset applied on the intermediate reference sub-signal corresponding to the sub-circuit, and record the first quantity of delaying units in the second circuit which the reference sub-signal corresponding to the sub-circuit has passed during its transmission, when entering the second state under which the memory is incapable to obtain the signal consistent with the respective sub-signal from a corresponding tap in the second circuit.

In the foregoing embodiments, the first circuit first applies the initial temporal offset on the reference sub-signal corresponding to the sub-circuit, so as to obtain the intermediate reference sub-signal corresponding to the sub-circuit. At such time, the intermediate reference sub-signal corresponding to the sub-circuit may not be aligned with the sampling edge of the sampling signal. In case of the first state under which the memory is capable to obtain the signal consistent with the respective sub-signal through sampling the respective reference sub-signal with the sampling signal, the intermediate reference sub-signal corresponding to the sub-circuit is further controlled to pass through the delaying unit(s) in the second circuit successively to increase the temporal offset applied on the intermediate reference sub-signal corresponding to the sub-circuit, and the first quantity of delaying units in the second circuit which the reference sub-signal corresponding to the sub-circuit has passed during its transmission is immediately recorded when the second state is entered. In this way, the first adjustment information accurately representing the critical state at one edge of the data window of the reference sub-signal corresponding to the sub-circuit can be recorded, thereby further improving accuracy of the obtained adjustment information.

In all embodiments of the present disclosure, the second adjustment information may include a second quantity of the delaying units through which the respective reference sub-signal does not pass. Adjusting the temporal offset to decrease the delay of the respective reference sub-signal of said sub-circuit, until said sub-circuit enters the second state, to obtain the second adjustment information of said sub-circuit includes: decreasing a delay of the intermediate reference sub-signal through reducing a quantity of the delaying units through which the respective reference sub-signal passes, until the memory is incapable to obtain the signal consistent with the respective sub-signal through sampling the respective reference sub-signal with the sampling signal from the tap of the last delaying unit through which the respective reference sub-signal passes; and recording the second quantity of the delaying units through which the respective reference sub-signal of said sub-circuit does not pass, when the memory is incapable to obtain the signal consistent with the respective reference sub-signal from the tap of the last delaying unit through which the respective reference sub-signal passes.

Specifically, the computer device may restore the second state to the previous first state, that is, restore the second state, under which the memory is incapable to obtain the signal consistent with the respective sub-signal through sampling the respective reference sub-signal with the sampling signal, to the first state, under which the memory is capable to obtain the signal consistent with the respective sub-signal through sampling the respective reference sub-signal with the sampling signal, at an earlier stage of the training. Then the computer device may control the intermediate reference sub-signal corresponding to the sub-circuit to pass through the delaying units in the first circuit successively while decreasing the temporal offset applied on the intermediate reference sub-signal corresponding to the sub-circuit, and the computer device may record the second quantity of delaying unit(s) which the reference sub-signal corresponding to the sub-circuit has not passed when the second state, under which the memory is incapable to obtain the signal consistent with the respective sub-signal from a corresponding tap in the first circuit, is entered.

In the foregoing embodiments, the intermediate reference sub-signal corresponding to the sub-circuit is controlled to pass the delaying units in the first circuit successively while decreasing the temporal offset applied on the intermediate reference sub-signal corresponding to the sub-circuit, and the second quantity of delaying units which the reference sub-signal corresponding to the sub-circuit has not passed is immediately recorded when the second state is entered. In this way, the second adjustment information accurately representing the critical state at the other edge of the data window of the reference sub-signal corresponding to the sub-circuit can be recorded, thereby further improving the accuracy of the obtained adjustment information.

In all embodiments of the present disclosure, determining the adjustment information for said sub-circuit based on the first adjustment information and the second adjustment information may include: determining the adjustment information based on an average of the first quantity and the second quantity.

Specifically, the computer device may calculate the average of the first quantity and the second quantity, so as to obtain the adjustment information for the sub-circuit based on such average.

In all embodiments of the present disclosure, the computer device may determine the calculated average of the first quantity and the second quantity directly as the adjustment information for the sub-circuit.

In the foregoing embodiments, the adjustment information is determined by using the average of the first quantity and the second quantity, so as to further improve the accuracy of the adjustment information.

In all embodiments of the present disclosure, as shown in FIG. 17, each sub-circuit of the circuit for controlling the delay of writing-data signals may include a step counter. The step counter may be configured to record the first quantity of delaying units in the second circuit which the writing-data signal has passed, and record the second quantity of delaying units which the writing-data signal has not passed.

In all embodiments of the present disclosure, before the adjusting, before adjusting the temporal offset to increase the delay of the respective reference sub-signal of said sub-circuit, the method may further include: reducing, when said sub-circuit is in the second state, a current operating frequency of the memory to obtain a target operating frequency, where the target operating frequency is an operating frequency at which the memory is capable to obtain the signal consistent with the respective sub-signal through sampling the respective reference sub-signal with the sampling signal; and sampling, through the memory operating at the target operating frequency, the respective reference sub-signal of the sub-circuit with the sampling signal.

The current operating frequency is of the memory, that is, is an operating frequency of the memory when the memory has not sampled the reference sub-signal corresponding to the sub-circuit with the sampling signal. The target operating frequency is a frequency reduced based on the current operating frequency.

Specifically, for each sub-circuit in the circuit for controlling the delay of writing-data signals, the computer device may transmit the reference sub-signal corresponding to the sub-circuit to the memory by using the host, and sample the reference sub-signal corresponding to the sub-circuit with the sampling signal of the memory. The second state, under which the memory is incapable to obtain the signal consistent with the respective sub-signal through sampling the respective reference sub-signal with the sampling signal, may indicate that the current operating frequency of the memory is too high, and hence a period in which the reference sub-signal corresponding to the sub-circuit is at a high level is too short. As a result, the memory cannot obtain the signal consistent with the reference sub-signal corresponding to the sub-circuit with the sampling signal. In this case, the computer device may reduce the current operating frequency of the memory to the target operating frequency. It can be understood that the operating frequency of the memory is reduced to prolong the period in which the reference sub-signal corresponding to the sub-circuit stays in the high level, and the memory operating at the target operating frequency can smoothly sample the reference sub-signal corresponding to the sub-circuit. Then the computer device may sample the reference sub-signal corresponding to the sub-circuit based on the memory operating at the target operating frequency, that is, the memory samples the reference sub-signal corresponding to the sub-circuit. Afterward, when entering the first state under which the memory is capable to obtain the signal consistent with the respective sub-signal through sampling the respective reference sub-signal with the sampling signal, the step of adjusting the temporal offset to increase the delay of the respective reference sub-signal of said sub-circuit may be performed.

In the foregoing embodiments, after the memory receives the reference sub-signal corresponding to the sub-circuit transmitted by the host, if the memory cannot obtained the signal consistent with the reference sub-signal corresponding to the sub-circuit through sampling with the sampling signal, it means that the sampling edge of the sampling signal has drifted out of the data window in the reference sub-signal corresponding to the sub-circuit. In this case, the current operating frequency of the memory is reduced until the target operating frequency is reached, and the memory operating at the target operating frequency can prolong the period in which the reference sub-signal corresponding to the sub-circuit keeps the high level. Then, the memory may sample the reference sub-signal corresponding to the sub-circuit with the sampling signal, which renders the offset adjustment training more likely to converge.

In all embodiments of the present disclosure, after training the circuit f through adjusting the temporal offset applied by the circuit on the reference writing-data signal to obtain the trained circuit, the foregoing method for controlling delay of writing-data signals may further include: triggering, through a timer, configuring the register mode of the register circuit in the memory through hardware control and the host, to perform the training again.

Specifically, a timer is deployed in the computer device. The computer device may periodically utilizes the timer to trigger a step of configuring the register mode of the register circuit in the memory through hardware control and the host to obtain the training register for caching data, so as to repeat the offset adjustment training. It may be understood that the computer device may utilizes the timer for timing, where the offset adjustment training through hardware control is repeated in preset intervals.

For example, the computer device may perform the timing by using the timer, and the offset adjustment training through hardware control is repeated once every 24 hours.

In the foregoing embodiments, the training on the circuit for controlling the delay of writing-data signals through hardware control is periodically triggered by using the timer, so as to ensure that there is no temporal offset between the writing-data signal and the sampling edge of the sampling signal during operation of the computer device, further improving operation stability of the memory.

In all embodiments of the present disclosure, after training the circuit through adjusting the temporal offset applied by the circuit on the reference writing-data signal to obtain the trained circuit, the method may further include: monitoring an operating state of a high-bandwidth memory system, the high-bandwidth memory system including the host and the memory; and configuring, through the host and software control in response to the operating state is an idle state, the operating mode of the register circuit in the memory again to obtain the training register to trigger the training again.

Specifically, the high-bandwidth memory system is deployed in the computer device, and the computer device may monitor the operating state of the high-bandwidth memory system. If it is detected that the system operating state of the high-bandwidth memory system is in the idle state, the computer device may repeat, through software control and the host, the operation of configuring the operating mode of the register circuit in the memory, so as to obtain the training register for caching data and hence trigger the offset adjustment training again. If it is detected that the system operating state of the high-bandwidth memory system is in a busy state, the computer device may temporarily not perform the offset adjustment training through software control until it is detected that the system operating state of the high-bandwidth memory system is in the idle state next time.

In the foregoing embodiments, the circuit for controlling the delay of writing-data signals may be retrained through software control when the high-bandwidth memory system is not busy, so as to further ensure that no temporal offset exists between the writing-data signal and the sampling edge of the sampling signal during operation of the computer device, further improving operation stability of the memory. In addition, the circuit for controlling the delay of writing-data signals is retrained when the high-bandwidth memory system is not busy, which may also ensure operating efficiency of the entire high-bandwidth memory system.

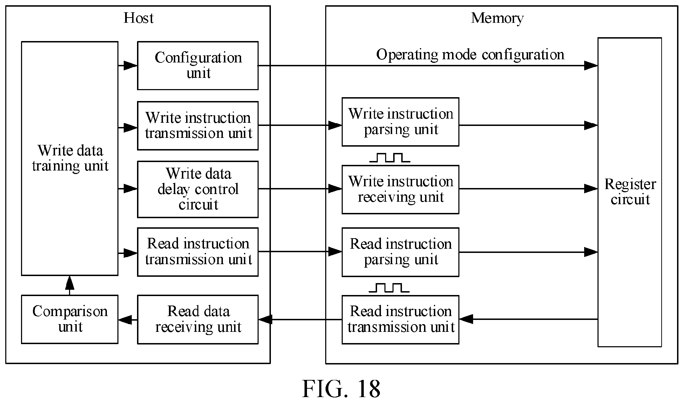

In an embodiment of the present disclosure, as shown in FIG. 18, a high-bandwidth memory system runs in a computer device. The high-bandwidth memory system includes a host and a memory. The host includes a configuration unit, a write instruction transmission unit, the circuit for controlling the delay of writing-data signals, a read instruction transmission unit, a read data receiving unit, a comparison unit, and a write data training unit. The memory includes a write instruction parsing unit, a write instruction receiving unit, a read instruction parsing unit, a read instruction transmission unit, and a register circuit. The computer device configures an operating mode of the register circuit in the memory through the configuration unit, to configure a memory circuit to operate in the read-write mode to obtain the training register. The host may transmit a write instruction to the memory, and the memory may parse the write instruction through the write instruction parsing unit. After the write instruction is parsed, the host may transmit the reference writing-data signal to the memory, and the memory may receive the reference writing-data signal through the write instruction receiving unit. Then the memory may sample the reference writing-data signal with the sampling signal, and write the sampled writing-data signal obtained from the sampling into the training register. The host may transmit a read instruction to the memory by using the read instruction transmission unit, and the memory may parse the read instruction by using the read instruction parsing unit. After the read instruction is parsed, the memory may read the sampled writing-data signal from the training register, and transmit the sampled writing-data signal to the host by using the read instruction transmission unit. The host may receive the sampled writing-data signal by using the read data receiving unit, and forward the sampled writing-data signal to the comparison unit. The host may compare the sampled writing-data signal with the reference writing-data signal by using the comparison unit. In a case that the sampled writing-data signal read by the host from the training register is inconsistent with the reference writing-data signal, the computer device may perform the offset adjustment training, which controls the temporal offset applied on the writing-data signals, on the circuit, which is arranged on the host, based on the reference writing-data signal to obtain the trained circuit. Then in actual application, the computer device may adjust the temporal offset applied on an inputted writing-data signal by using the trained circuit, thus obtain the target writing-data signal aligned with the sampling edge of the sampling signal, and write the target writing-data signal into the memory.

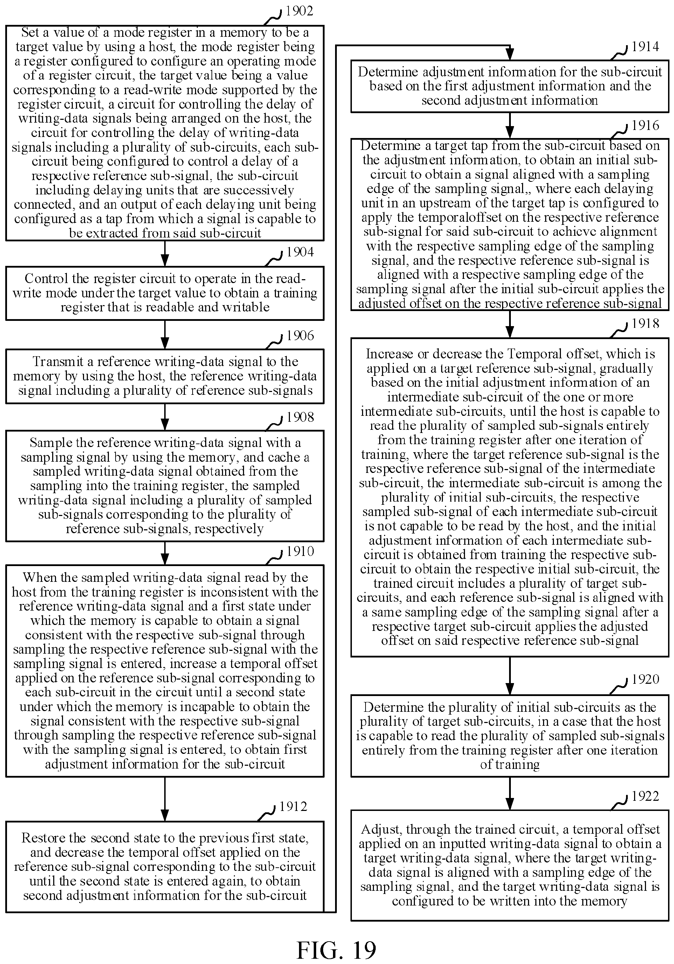

As shown in FIG. 19, in an embodiment, a method for controlling delay of writing-data signals is provided. The method may be applied to a computer device. The computer device may be a terminal or a server. The method may be performed by the terminal or the server independently, or may be implemented through interaction between the terminal and the server. The method specifically includes the following steps:

Step 1902: Set a value of a mode register in a memory to be a target value by using a host, the mode register being a register configured to configure an operating mode of a register circuit, the target value being a value corresponding to a read-write mode supported by the register circuit, a circuit for controlling the delay of writing-data signals with respect to the sampling signal being arranged on the host, the circuit for controlling the delay of writing-data signals including a plurality of sub-circuits, each sub-circuit being configured to control a delay of a respective reference sub-signal, the sub-circuit including delaying units that are successively connected, and an output of each delaying unit being configured as a tap from which a signal is capable to be extracted from said sub-circuit.

Step 1904: Control the register circuit to operate in the read-write mode under the target value to obtain a training register that is readable and writable.

Step 1906: Transmit a reference writing-data signal to the memory by using the host, the reference writing-data signal including a plurality of reference sub-signals.

Step 1908: Sample the reference writing-data signal with a sampling signal by using the memory, and cache a sampled writing-data signal obtained from the sampling into the training register, the sampled writing-data signal including a plurality of sampled sub-signals corresponding to the plurality of reference sub-signals, respectively.

Step 1910: when the sampled writing-data signal read by the host from the training register is inconsistent with the reference writing-data signal and a first state under which the memory is capable to obtain a signal consistent with the respective sub-signal through sampling the respective reference sub-signal with the sampling signal is entered, increase a temporal offset applied on the reference sub-signal corresponding to each sub-circuit in the circuit for controlling the delay of writing-data signals until a second state under which the memory is incapable to obtain the signal consistent with the respective sub-signal through sampling the respective reference sub-signal with the sampling signal is entered, to obtain first adjustment information for the sub-circuit.

Step 1912: Restore the second state to the previous first state, and decrease the temporal offset applied on the reference sub-signal corresponding to the sub-circuit until the second state is entered again, to obtain second adjustment information for the sub-circuit.

Step 1914: Determine adjustment information for the sub-circuit based on the first adjustment information and the second adjustment information.

Step 1916: Determine a target tap from the sub-circuit based on the adjustment information, to obtain an initial sub-circuit to obtain a signal aligned with a sampling edge of the sampling signal, where each delaying unit in an upstream of the target tap is configured to apply the temporal offset on the respective reference sub-signal for said sub-circuit to achieve alignment with the respective sampling edge of the sampling signal, and the respective reference sub-signal is aligned with a respective sampling edge of the sampling signal after the initial sub-circuit applies the adjusted temporal offset on the respective reference sub-signal.

Step 1918: Increase or decrease the temporal offset, which is applied on a target reference sub-signal, gradually based on the initial adjustment information of an intermediate sub-circuit of the one or more intermediate sub-circuits, until the host is capable to read the plurality of sampled sub-signals entirely from the training register after one iteration of training, where the target reference sub-signal is the respective reference sub-signal of the intermediate sub-circuit, the intermediate sub-circuit is among the plurality of initial sub-circuits, the respective sampled sub-signal of each intermediate sub-circuit is not capable to be read by the host, and the initial adjustment information of each intermediate sub-circuit is obtained from training the respective sub-circuit to obtain the respective initial sub-circuit, the trained circuit includes a plurality of target sub-circuits, and each reference sub-signal is aligned with a same sampling edge of the sampling signal after a respective target sub-circuit applies the adjusted temporal offset on said respective reference sub-signal.

Step 1920: Determine the plurality of initial sub-circuits as the plurality of target sub-circuits, in a case that the host is capable to read the plurality of sampled sub-signals entirely from the training register after one iteration of training.

Step 1922: Adjust, through the trained circuit, a temporal offset applied on an inputted writing-data signal to obtain a target writing-data signal, where the target writing-data signal is aligned with a sampling edge of the sampling signal, and the target writing-data signal is configured to be written into the memory.

This application further provides an application scenario. The foregoing method for controlling delay of writing-data signals is applied to the application scenario. Specifically, a high-bandwidth memory system is deployed in a computer device. The high-bandwidth memory system includes a host and a DRAM. The method for controlling delay of writing-data signals may be applied to a scenario for writing-data signal delay control when the high-bandwidth memory system is in an operating state. The computer device may set a value of a mode register in the DRAM to a target value by using the host. The mode register is a register configured to configure an operating mode of a register circuit. The target value is a value corresponding to a read-write mode supported by the register circuit. A circuit for controlling the delay of writing-data signals with respect to the sampling signal is arranged on the host. The circuit for controlling the delay of writing-data signals includes a plurality of sub-circuits. Each sub-circuit is configured to control a delay of a respective reference sub-signal. The sub-circuit includes delaying units that are successively connected. An output terminal of each of the delaying units serves as a tap from which a signal can be outputted from the sub-circuit. The register circuit is controlled, by using the target value, to operate in the read-write mode, to obtain a training register that is readable and writable. A reference writing-data signal is transmitted to the DRAM by using the host. The reference writing-data signal includes a plurality of reference sub-signals.

The computer device may be configured to sample the reference writing-data signal based on a sampling signal by using the DRAM, and cache a sampled writing-data signal obtained from the sampling into the training register. The sampled writing-data signal includes a plurality of sampled sub-signals respectively corresponding to the plurality of reference sub-signals. In a case that the sampled writing-data signal read by the host from the training register is inconsistent with the reference writing-data signal, for each sub-circuit in the circuit for controlling the delay of writing-data signals, in a first state under which the memory is capable to obtain a signal consistent with the respective sub-signal through sampling the respective reference sub-signal with the sampling signal, the sub-circuit is adjusted through increasing a temporal offset applied on the reference sub-signal corresponding to the sub-circuit, so as to obtain first adjustment information for the sub-circuit when entering a second state under which the memory is incapable to obtain the signal consistent with the respective sub-signal through sampling the respective reference sub-signal with the sampling signal. The second state is then restored to the previous first state, and the sub-circuit is adjusted through decreasing the temporal offset applied on the reference sub-signal corresponding to the sub-circuit, so as to obtain second adjustment information for the sub-circuit when the second state is entered again. Adjustment information for the sub-circuit is determined based on the first adjustment information and the second adjustment information. A target tap is determined from the sub-circuit based on the adjustment information, to obtain an initial sub-circuit. Target delaying unit(s) in the upstream of the target tap is configured to adjust the temporal offset applied on the reference sub-signal corresponding to the sub-circuit through delaying processing, so as to obtain a signal aligned with a sampling edge of the sampling signal. The reference sub-signal on which the temporal offset has been applied by the initial sub-circuit is aligned with the sampling edge of the sampling signal.

In a case that the host cannot read the plurality of sampled sub-signals entirely from the training register after one iteration, the computer device may gradually adjust, based on initial adjustment information of the intermediate sub-circuit, the intermediate sub-circuit through increasing or decreasing the temporal offset applied on the target reference sub-signal, until the host is capable to read the plurality of sampled sub-signals entirely from the training register after one iteration, so as to obtain the trained circuit. The target reference sub-signal is an intermediate reference sub-signal corresponding to the sub-circuit. The intermediate sub-circuit refers to the initial sub-circuit corresponding to the reference sub-signal which cannot be read from the training register currently. The initial adjustment information of the intermediate sub-circuit is adjustment information obtained during the corresponding single-circuit offset adjustment training which leads to the initial sub-circuit. The trained circuit includes a plurality of target sub-circuits. All reference sub-signals on which the temporal offsets have been applied by the respective target sub-circuits are aligned with the same sampling edge of the sampling signal. The initial sub-circuits serve as the target sub-circuits in a case that the host is capable to read the plurality of sampled sub-signals entirely from the training register after one iteration, so as to obtain the trained circuit.

The computer device may adjust the temporal offset applied on an inputted writing-data signal by using the trained circuit, to obtain a target writing-data signal aligned with the sampling edge of the sampling signal. The target writing-data signal is to be written into the DRAM.

This application further provides an application scenario. The foregoing method for controlling delay of writing-data signals is applied to the application scenario. Specifically, a high-bandwidth memory system is deployed in a computer device. The high-bandwidth memory system includes a host and a memory. The method for controlling delay of writing-data signals may be applied to a scenario for writing-data signal delay control when the high-bandwidth memory system is in an idle state. Through the method for controlling delay of writing-data signals in this application, the offset adjustment training is performed on the circuit for controlling the delay of writing-data signals in the high-bandwidth memory system in the idle state, which ensures correctness of data written to the memory by the high-bandwidth memory system in the subsequent operating state, thereby improving operating stability of the memory.

It is to be understood that, although the steps are displayed sequentially in the flowcharts of the embodiments, these steps are not necessarily performed sequentially according to the sequence. Unless otherwise explicitly specified in this specification, execution of the steps is not strictly limited, and the steps may be performed in another sequence. Moreover, at least some of the steps in each embodiment may include a plurality of sub-steps or a plurality of stages. The sub-steps or stages are not necessarily performed at the same moment but may be performed at different moments. Execution of the sub-steps or stages is not necessarily sequentially performed, but may be performed alternately with other steps or at least some of sub-steps or stages of other steps.

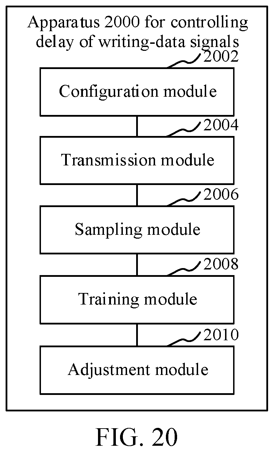

In an embodiment, as shown in FIG. 20, an apparatus 2000 for controlling delay of writing-data signals 2000 is provided. The apparatus may adopt a software module, a hardware module, or a combination thereof to become a part of a computer device. The apparatus specifically includes:
a configuration module 2002, configured to configure, through a host, an operating mode of a register circuit in a memory to obtain a training register which is readable and writable;
a transmission module 2004, configured to transmit, through the host, a reference writing-data signal to the memory;
a sampling module 2006, configured to sample, through the memory, the reference writing-data signal with a sampling signal to obtain a sampled writing-data signal, and caching the sampled writing-data signal into the training register;
a training module 2008, configured to train, in a case that the sampled writing-data signal read by the host from the training register is inconsistent with the reference writing-data signal, a circuit, which is configured to control the delay of writing-data signals with respect to the sampling signal and arranged on the host, through adjusting a temporal offset applied by the circuit on the reference writing-data signal, until the sampled writing-data signal read by the host from the training register is consistent with the reference writing-data signal, to obtain a trained circuit; and
an adjustment module 2010, configured to adjust, through the trained circuit, a temporal offset applied on an inputted writing-data signal to obtain a target writing-data signal, where the target writing-data signal is aligned with a sampling edge of the sampling signal, and the target writing-data signal is configured to be written into the memory.

In all embodiments of the present disclosure, the configuration module 2002 may be configured to set, through the host, a value of a mode register in the memory to be a target value, where the operating mode of the register circuit is capable to be configured through the mode register, and the target value indicates that the register circuit is readable and writable. The operating mode of the register circuit is controlled to be a read-write mode under the target value to obtain the training register.

In all embodiments of the present disclosure, the reference writing-data signal may include a plurality of reference sub-signals, the circuit on the host includes a plurality of sub-circuits, each sub-circuits is configured to control a delay of a respective reference sub-signal. The training module 2008 is further configured to: train each sub-circuit through adjusting a temporal offset applied by said sub-circuit on the respective reference sub-signal to obtain an initial sub-circuit, where the respective reference sub-signal is aligned with a respective sampling edge of the sampling signal after the initial sub-circuit applies the adjusted temporal offset on the respective reference sub-signal; and train the plurality of initial sub-circuits through adjusting temporal offsets applied by the plurality of initial sub-circuits on the plurality of reference sub-signals to obtain the trained circuit, where the trained circuit includes a plurality of target sub-circuits, and each reference sub-signal is aligned with a same sampling edge of the sampling signal after a respective target sub-circuit applies the adjusted temporal offset on said respective reference sub-signal.

In all embodiments of the present disclosure, the sampled writing-data signal may include a plurality of sampled sub-signals, and each sampled sub-signal is obtained through sampling a respective reference sub-signal of the plurality of reference sub-signals. The training module 2008 is further configured to: in a case that the host is incapable to read the plurality of sampled sub-signals entirely from the training register after one iteration of training, keep training one or more intermediate sub-circuits based on initial adjustment information of the one or more intermediate sub-circuits until the host is capable to read the plurality of sampled sub-signals entirely from the training register after one iteration of training, where the one or more intermediate sub-circuit are among the plurality of initial sub-circuits, the respective sampled sub-signal of each intermediate sub-circuit is not capable to be read by the host, and the initial adjustment information of each intermediate sub-circuit is obtained from training the respective sub-circuit to obtain the respective initial sub-circuit.

In all embodiments of the present disclosure, the training module 2008 may be further configured to increase or decrease the temporal offset, which is applied on a target reference sub-signal, gradually based on the initial adjustment information of an intermediate sub-circuit of the one or more intermediate sub-circuits, until the host is capable to read the plurality of sampled sub-signals entirely from the training register after one iteration of training. The target reference sub-signal is the respective reference sub-signal of the intermediate sub-circuit.

In all embodiments of the present disclosure, the training module 2008 may be further configured to determine the plurality of initial sub-circuits as the plurality of target sub-circuits, in a case that the host is capable to read the plurality of sampled sub-signals entirely from the training register after one iteration of training.

In all embodiments of the present disclosure, each sub-circuit includes delaying units that are successively connected, an output terminal of each of the delaying units may be configured as a tap from which a signal is capable to be extracted from said sub-circuit, and a target tap is determined from the taps for the initial sub-circuit. The training module 2008 is further configured to: train each sub-circuit through adjusting the temporal offset applied by said sub-circuit on the respective reference sub-signal to determine adjustment information for said sub-circuit; and determine the target tap from the taps in each sub-circuit based on the adjustment information, where each delaying unit in an upstream of the target tap is configured to apply the temporal offset on the respective reference sub-signal for said sub-circuit to achieve alignment with the respective sampling edge of the sampling signal.

In all embodiments of the present disclosure, the training module 2008 may be further configured to, for each sub-circuit, when said sub-circuit is in a first state under which the memory is capable to obtain a signal consistent with the respective sub-signal through sampling the respective reference sub-signal with the sampling signal: adjust the temporal offset to increase a delay of the respective reference sub-signal of said sub-circuit, until said sub-circuit enters a second state under which the memory is incapable to obtain the signal consistent with the respective sub-signal through sampling the respective reference sub-signal with the sampling signal, to obtain first adjustment information of said sub-circuit; restore said sub-circuit from the second state to the first state; adjust the temporal offset to decrease the delay of the respective reference sub-signal of said sub-circuit, until said sub-circuit enters the second state, to obtain second adjustment information of said sub-circuit; and determine the first adjustment information and the second adjustment information to serve as the adjustment information for said sub-circuit.

In all embodiments of the present disclosure, each sub-circuit may include a first circuit and a second circuit, an input of the second circuit is connected with an output of the first circuit, the first circuit and the second circuit each includes a part of the delaying units that are successively connected, the first adjustment information includes a first quantity of the delaying units in the second circuit through which the respective reference sub-signal of said sub-circuit passes. The training module 2008 is further configured to: control the respective reference sub-signal to pass through the delaying units in the first circuit successively to obtain an intermediate reference sub-signal; and when said sub-circuit is in the first state under which the memory is capable to obtain the signal consistent with the respective sub-signal through sampling the respective reference sub-signal with the sampling signal: increase a delay of the intermediate reference sub-signal through controlling the respective reference sub-signal to pass further through the delaying units in the second circuit successively, until said sub-circuit enters the second state, where the second state is that the memory is incapable to obtain the signal consistent with the respective sub-signal through sampling the respective reference sub-signal with the sampling signal from the tap of a last delaying unit through which the respective reference sub-signal passes; and record the first quantity of the delaying units in the second circuit through which the respective reference sub-signal of said sub-circuit passes, when said sub-circuit enters the second state.

In all embodiments of the present disclosure, the second adjustment information may include a second quantity of the delaying units through which the respective reference sub-signal does not pass. The training module 2008 is further configured to: decrease a delay of the intermediate reference sub-signal through reducing a quantity of the delaying units through which the respective reference sub-signal passes, until the memory is incapable to obtain the signal consistent with the respective sub-signal through sampling the respective reference sub-signal with the sampling signal from the tap of the last delaying unit through which the respective reference sub-signal passes; and record the second quantity of the delaying units through which the respective reference sub-signal of said sub-circuit does not pass, when the memory is incapable to obtain the signal consistent with the respective reference sub-signal from the tap of the last delaying unit through which the respective reference sub-signal passes.

In all embodiments of the present disclosure, the training module 2008 may be further configured to: reduce, when said sub-circuit is in the second state, a current operating frequency of the memory to obtain a target operating frequency, where the target operating frequency is an operating frequency at which the memory is capable to obtain the signal consistent with the respective sub-signal through sampling the respective reference sub-signal with the sampling signal; and sample, through the memory operating at the target operating frequency, the respective reference sub-signal of the sub-circuit with the sampling signal.

In all embodiments of the present disclosure, the training module 2008 may be further configured to monitor an operating state of a high-bandwidth memory system, the high-bandwidth memory system including the host and the memory; and configure, through the host and software control in response to the operating state is an idle state, the operating mode of the register circuit in the memory again to obtain the training register to trigger the training again.

In all embodiments of the present disclosure, the transmission module 2004 may be further configured to transmit, through the host, the reference writing-data signal and a pulse signal for selecting writing data to the memory, where the pulse signal matches the reference writing-data signal. The sampling module 2006 is further configured to: use the pulse signal for selecting writing data received by the memory as the sampling signal; and determine, through the memory, the pulse signal as the sampling signal.

In all embodiments of the present disclosure, the sampling edge of the sampling signal may include a rising edge. The sampling module 2006 is further configured to sample, through the memory, the reference writing-data signal with the rising edge. The target writing-data signal is aligned with the rising edge of the sampling signal.

In all embodiments of the present disclosure, the sampling edge of the sampling signal may include a falling edge. The sampling module 2006 is further configured to sample, through the memory, the reference writing-data signal with the falling edge. The target writing-data signal is aligned with the falling edge of the sampling signal.

In the foregoing apparatus for controlling delay of writing-data signals, the operating mode of the register circuit in a memory configured through the host to obtain the training register which is readable and writable. The reference writing-data signal is transmitted through the host to the memory. The reference writing-data signal is sampled through the memory with the sampling signal with the sampling signal to obtain the sampled writing-data signal, and the sampled writing-data signal is cached into the training register. The sampled writing-data signal is compared with the reference writing-data signal transmitted from the host. The sampled writing-data signal read by the host from the training register being inconsistent with the reference writing-data signal indicates that there is a temporal offset between the reference writing-data signal transmitted from the host and the sampling signal of the memory. In such case, the circuit which is for controlling the delay of writing-data signals with respect to the sampling signal and arranged on the host, may be trained through adjusting the temporal offset applied by the circuit on the reference writing-data signal based on the reference writing-data signal, so as to obtain the trained circuit. In an actual operation, the temporal offset applied on the inputted writing-data signal may be adjusted through the trained circuit, and the target writing-data signal is configured to be written into the memory. Thereby, the target writing-data signal received by the memory can be aligned with the sampling edge of the sampling signal, so that the memory can correctly sample the writing-data signal transmitted from the host. Correctness of data written into the memory is ensured, and operation stability of the memory is improved.

The modules in the foregoing apparatus for controlling delay of writing-data signals may be implemented in whole or in part by software, hardware, or a combination thereof. The foregoing modules may be built in or independent of a processor of a computer device in a form of hardware, or may be stored in a storage of the computer device in a form of software, so that the processor invokes each of the foregoing modules to perform an operation corresponding to the module.

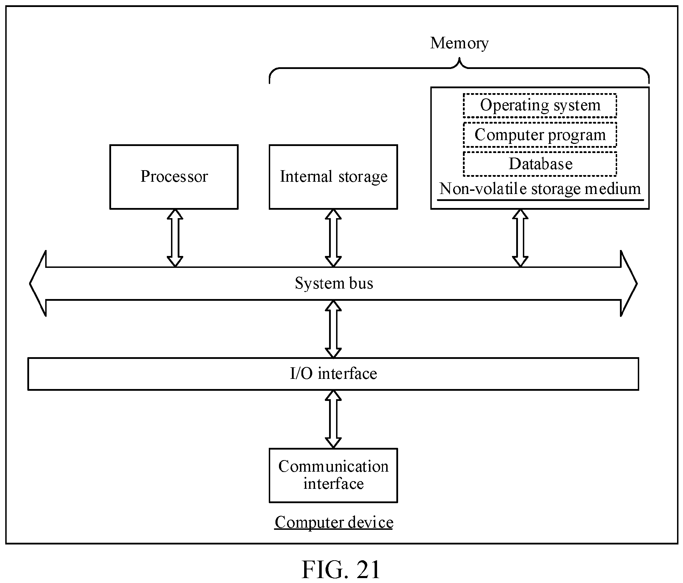

In an embodiment of the present disclosure, a computer device is provided. The computer device may be a server. An internal structure diagram of the server may be shown in FIG. 21. The computer device includes a processor, a storage, an input/output (I/O for short) interface, and a communication interface. The processor, the memory, and the I/O interface are connected through a system bus, and the communication interface is connected to the system bus through the I/O interface. The processor of the computer device is configured to provide computing and control capabilities. The memory of the computer device includes a non-volatile storage medium and an internal memory. The non-volatile storage medium has an operating system, a computer-readable instruction, and a database stored therein. The internal memory provides an environment for running of the operating system and the computer-readable instruction in the non-volatile storage medium. The I/O interface of the computer device is configured to exchange information between the processor and an external device. The communication interface of the computer device is configured to connect to and communicate with an external terminal through a network. The computer-readable instruction, when executed by the processor, implements a method for controlling delay of writing-data signals.

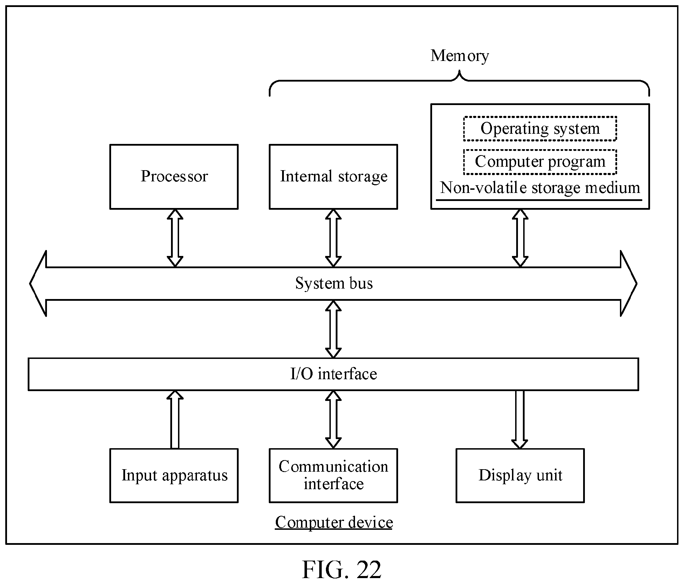

In an embodiment of the present disclosure, a computer device is provided. The computer device may be a terminal. An internal structure diagram of the terminal may be shown in FIG. 22. The computer device includes a processor, a memory, an I/O interface, a communication interface, a display unit, and an input apparatus. The processor, the memory, and the I/O interface are connected through a system bus. The communication interface, the display unit, and the input apparatus are connected to the system bus through the I/O interface. The processor of the computer device is configured to provide computing and control capabilities. The memory of the computer device includes a non-volatile storage medium and an internal memory. The non-volatile storage medium has an operating system and a computer-readable instruction stored therein. The internal memory provides an environment for running of the operating system and the computer-readable instruction in the non-volatile storage medium. The I/O interface of the computer device is configured to exchange information between the processor and an external device. The communication interface of the computer device is used for wired or wireless communication with an external terminal. The wireless communication may be implemented through Wi-Fi, a mobile cellular network, near field communication (NFC), or other technologies. The computer-readable instruction, when executed by the processor, implements a method for controlling delay of writing-data signals. The display unit of the computer device is configured to form a visually visible picture, and may be a display screen, a projection apparatus, or a virtual reality imaging apparatus. The display screen may be a liquid crystal display screen or an electronic ink display screen. The input apparatus of the computer device may be a touch layer covering the display screen, or may be a key, a trackball, or a touch pad arranged on a housing of the computer device, and may further be an external keyboard, a touch pad, a mouse, or the like.

A person skilled in the art may understand that, the structures shown in FIG. 21 and FIG. 22 are merely block diagrams of partial structures related to the solutions in this application, and do not constitute a limitation on the computer device to which the solution in this application is applied. Specifically, the computer device may include more or fewer components than those shown in the figure, or some merged components, or different component arrangements.

In an embodiment of the present disclosure, a computer device is further provided, including a memory and one or more processors. The memory has computer-readable instructions stored therein. The one or more processors, when executing the computer-readable instructions, implement the steps in the foregoing method embodiments.

In an embodiment of the present disclosure, one or more computer-readable storage media are provided, having computer-readable instructions stored therein. The computer-readable instructions, when executed by one or more processors, implement the steps in the foregoing method embodiments.

In an embodiment of the present disclosure, a computer program product is further provided, including a computer-readable instruction, the computer-readable instruction, when executed by one or more processors, implementing the steps in the foregoing method embodiments.

User information (including but not limited to user equipment information, user personal information, and the like) and data (including but not limited to data for analysis, stored data, displayed data, and the like) involved in this application are all information and data authorized by users or fully authorized by all parties. The collection, use, and processing of relevant data need to comply with the relevant laws, regulations, and standards of relevant countries and regions.

A person of ordinary skill in the art may understand that all or some of processes of the method in the foregoing embodiments may be performed by using a computer-readable instruction to instruct relevant hardware. The computer-readable instruction may be stored in a non-volatile computer-readable storage medium. When the computer-readable instruction is executed, the processes of the foregoing method embodiments may be included. Any reference to the memory, the storage medium, the database, or other media used in the embodiments provided in this application may include at least one of a non-volatile memory and a volatile memory. The non-volatile memory may include a read-only memory (ROM), a magnetic tape, a floppy disk, a flash memory, an optical memory, or the like. The volatile memory may include a RAM or an external cache. As a description rather than a limitation, the RAM may have various forms, such as a static RAM (SRAM) or a dynamic RAM (DRAM).

The technical features of the foregoing embodiments may be randomly combined. To make the description concise, not all possible combinations of the technical features in the foregoing embodiments are described. However, the combinations of these technical features are considered as falling within the scope recorded in this specification provided that no conflict exists.

The foregoing embodiments describe only some implementations of this application, which are described specifically and in detail, but cannot be construed as a limitation on the scope of the invention patent. For a person of ordinary skill in the art, some transformations and improvements may be made without departing from the idea of this application. These transformations and improvements belong to the protection scope of this application. Therefore, the protection scope of the patent of this application is subject to the appended claims.

## Claims

1. A method for controlling delay of writing-data signals, executable by a computer device, the method comprising:
configuring, through a host, an operating mode of a register circuit in a memory to obtain a training register which is readable and writable;
transmitting, through the host, a reference writing-data signal to the memory;
sampling, through the memory, the reference writing-data signal with a sampling signal to obtain a sampled writing-data signal, and caching the sampled writing-data signal into the training register;
training (208), in a case that the sampled writing-data signal read by the host from the training register is inconsistent with the reference writing-data signal, a circuit, which is configured to control the delay of writing-data signals with respect to the sampling signal, arranged on the host through adjusting a temporal offset applied by the circuit on the reference writing-data signal until the sampled writing-data signal read by the host from the training register is consistent with the reference writing-data signal, to obtain a trained circuit; and
adjusting, through the trained circuit, a temporal offset applied on an inputted writing-data signal to obtain a target writing-data signal that is aligned with a sampling edge of the sampling signal, and the target writing-data signal is configured to be written into the memory.

2. The method according to claim 1, wherein configuring, through the host, the operating mode of the register circuit in the memory comprises:
setting, through the host, a value of a mode register in the memory to be a target value, wherein the operating mode of the register circuit is capable to be configured through the mode register, and the target value indicates that the register circuit is readable and writable;
wherein the operating mode of the register circuit is controlled to be a read-write mode under the target value to obtain the training register.

3. The method according to claim 1, wherein the reference writing-data signal comprises a plurality of reference sub-signals, the circuit on the host comprises a plurality of sub-circuits, each sub-circuits is configured to control a delay of a respective reference sub-signal; and
training the circuit through adjusting the temporal offset applied by the circuit on the reference writing-data signal comprises:
training each sub-circuit through adjusting a temporal offset applied by said sub-circuit on the respective reference sub-signal to obtain an initial sub-circuit, wherein the respective reference sub-signal is aligned with a respective sampling edge of the sampling signal after the initial sub-circuit applies the adjusted temporal offset on the respective reference sub-signal; and
training a plurality of initial sub-circuits through adjusting temporal offsets applied by the plurality of initial sub-circuits on the plurality of reference sub-signals to obtain the trained circuit, wherein the trained circuit comprises a plurality of target sub-circuits, and each reference sub-signal is aligned with a same sampling edge of the sampling signal after a respective target sub-circuit applies the adjusted temporal offset on said respective reference sub-signal.

4. The method according to claim 3, wherein:
the sampled writing-data signal comprises a plurality of sampled sub-signals, and each sampled sub-signal is obtained through sampling a respective reference sub-signal of the plurality of reference sub-signals; and
training the plurality of initial sub-circuits through adjusting the temporal offsets applied by the plurality of initial sub-circuits on the plurality of reference sub-signals comprises, in a case that the host is incapable to read the plurality of sampled sub-signals entirely from the training register after one iteration of training:
keeping training one or more intermediate sub-circuits based on initial adjustment information of the one or more intermediate sub-circuits until the host is capable to read the plurality of sampled sub-signals entirely from the training register after one iteration of training;
wherein the one or more intermediate sub-circuit are among the plurality of initial sub-circuits, the respective sampled sub-signal of each intermediate sub-circuit is not capable to be read by the host, and the initial adjustment information of each intermediate sub-circuit is obtained from training the respective sub-circuit to obtain the respective initial sub-circuit.

5. The method according to claim 4, wherein keeping training the one or more intermediate sub-circuits based on the initial adjustment information of the one or more intermediate sub-circuits until the host is capable to read the plurality of sampled sub-signals entirely from the training register after one iteration of training comprises:
increasing or decreasing the temporal offset, which is applied on a target reference sub-signal, gradually based on the initial adjustment information of an intermediate sub-circuit of the one or more intermediate sub-circuits, until the host is capable to read the plurality of sampled sub-signals entirely from the training register after one iteration of training,
wherein the target reference sub-signal is the respective reference sub-signal of the intermediate sub-circuit.

6. The method according to claim 4, further comprising:
determining the plurality of initial sub-circuits as the plurality of target sub-circuits, in a case that the host is capable to read the plurality of sampled sub-signals entirely from the training register after one iteration of training.

7. The method according to claim 3, wherein each sub-circuit comprises delaying units that are successively connected, an output terminal of each of the delaying units is configured as a tap from which a signal is capable to be extracted from said sub-circuit, and a target tap is determined from the taps for the initial sub-circuit; and
training each sub-circuit through adjusting the temporal offset applied by said sub-circuit on the respective reference sub-signal comprises:
training each sub-circuit through adjusting the temporal offset applied by said sub-circuit on the respective reference sub-signal to determine adjustment information for said sub-circuit; and
determining the target tap from the taps in each sub-circuit based on the adjustment information, wherein each delaying unit in an upstream of the target tap is configured to apply the temporal offset on the respective reference sub-signal for said sub-circuit to achieve alignment with the respective sampling edge of the sampling signal.

8. The method according to claim 7, wherein training each sub-circuit through adjusting the temporal offset applied by said sub-circuit on the respective reference sub-signal to determine the adjustment information for said sub-circuit comprises:
for each sub-circuit, when said sub-circuit is in a first state under which the memory is capable to obtain a signal consistent with the respective sub-signal through sampling the respective reference sub-signal with the sampling signal:
adjusting the temporal offset to increase a delay of the respective reference sub-signal of said sub-circuit, until said sub-circuit enters a second state under which the memory is incapable to obtain the signal consistent with the respective sub-signal through sampling the respective reference sub-signal with the sampling signal, to obtain first adjustment information of said sub-circuit;
restoring said sub-circuit from the second state to the previous first state;
adjusting the temporal offset to decrease the delay of the respective reference sub-signal of said sub-circuit, until said sub-circuit enters the second state, to obtain second adjustment information of said sub-circuit; and
determining the adjustment information for said sub-circuit based on the first adjustment information and the second adjustment information.

9. The method according to claim 8, wherein each sub-circuit comprises a first circuit and a second circuit, an input of the second circuit is connected with an output of the first circuit, the first circuit and the second circuit each comprises a part of the delaying units that are successively connected, the first adjustment information comprises a first quantity of the delaying units in the second circuit through which the respective reference sub-signal of said sub-circuit passes; and
when said sub-circuit is in the first state under which the memory is capable to obtain the signal consistent with the respective sub-signal through sampling the respective reference sub-signal with the sampling signal, adjusting the temporal offset to increase the delay of the respective reference sub-signal of said sub-circuit, until said sub-circuit enters the second state under which the memory is incapable to obtain the signal consistent with the respective sub-signal through sampling the respective reference sub-signal with the sampling signal comprises:
controlling the respective reference sub-signal to pass through the delaying units in the first circuit successively to obtain an intermediate reference sub-signal; and
when said sub-circuit is in the first state under which the memory is capable to obtain the signal consistent with the respective sub-signal through sampling the respective reference sub-signal with the sampling signal,
increasing a delay of the intermediate reference sub-signal through controlling the respective reference sub-signal to pass further through the delaying units in the second circuit successively, until said sub-circuit enters the second state, wherein the second state is that the memory is incapable to obtain the signal consistent with the respective sub-signal through sampling the respective reference sub-signal with the sampling signal from the tap of a last delaying unit through which the respective reference sub-signal passes; and
recording the first quantity of the delaying units in the second circuit through which the respective reference sub-signal of said sub-circuit passes, when said sub-circuit enters the second state.

10. The method according to claim 9, wherein the second adjustment information comprises a second quantity of the delaying units through which the respective reference sub-signal does not pass; and
adjusting the temporal offset to decrease the delay of the respective reference sub-signal of said sub-circuit, until said sub-circuit enters the second state, to obtain the second adjustment information of said sub-circuit comprises:
decreasing a delay of the intermediate reference sub-signal through reducing a quantity of the delaying units through which the respective reference sub-signal passes, until the memory is incapable to obtain the signal consistent with the respective sub-signal through sampling the respective reference sub-signal with the sampling signal from the tap of the last delaying unit through which the respective reference sub-signal passes; and
recording the second quantity of the delaying units through which the respective reference sub-signal of said sub-circuit does not pass, when the memory is incapable to obtain the signal consistent with the respective reference sub-signal from the tap of the last delaying unit through which the respective reference sub-signal passes.

11. The method according to claim 8, wherein before adjusting the temporal offset to increase the delay of the respective reference sub-signal of said sub-circuit, the method further comprises:
reducing, when said sub-circuit is in the second state, a current operating frequency of the memory to obtain a target operating frequency, wherein the target operating frequency is an operating frequency at which the memory is capable to obtain the signal consistent with the respective sub-signal through sampling the respective reference sub-signal with the sampling signal; and
sampling, through the memory operating at the target operating frequency, the respective reference sub-signal of the sub-circuit with the sampling signal.

12. The method according to any one of claims 1 to 11, wherein after training the circuit through adjusting the temporal offset applied by the circuit on the reference writing-data signal to obtain the trained circuit, the method further comprises:
monitoring an operating state of a high-bandwidth memory system, the high-bandwidth memory system comprising the host and the memory; and
configuring, through the host and software control in response to the operating state is an idle state, the operating mode of the register circuit in the memory again to obtain the training register to trigger the training again.

13. The method according to claim 1, wherein transmitting, through the host, the reference writing-data signal to the memory comprises:
transmitting, through the host, the reference writing-data signal and a pulse signal for selecting writing data to the memory, wherein the pulse signal matches the reference writing-data signal; and
sampling, through the memory, the reference writing-data signal with the sampling signal comprises:
determining, through the memory, the pulse signal as the sampling signal.

14. The method according to claim 1, wherein the sampling edge of the sampling signal comprises a rising edge, and sampling, through the memory, the reference writing-data signal with the sampling signal comprises:
sampling, through the memory, the reference writing-data signal with the rising edge; and
wherein the target writing-data signal is aligned with the rising edge of the sampling signal.

15. The method according to claim 1, wherein the sampling edge of the sampling signal comprises a falling edge, and sampling, through the memory, the reference writing-data signal with the sampling signal comprises:
sampling, through the memory, the reference writing-data signal with the falling edge; and
wherein the target writing-data signal is aligned with the falling edge of the sampling signal.

16. An apparatus for controlling delay of writing-data signals, comprising:
a configuration module, configured to configure, through a host, an operating mode of a register circuit in a memory to obtain a training register which is readable and writable;
a transmission module, configured to transmit, through the host, a reference writing-data signal to the memory;
a sampling module, configured to sample, through the memory, the reference writing-data signal with a sampling signal to obtain a sampled writing-data signal, and caching the sampled writing-data signal into the training register;
a training module, configured to train, in a case that the sampled writing-data signal read by the host from the training register is inconsistent with the reference writing-data signal, a circuit, which is configured to control the delay of writing-data signals with respect to the sampling signal and arranged on the host through adjusting a temporal offset applied by the circuit on the reference writing-data signal, until the sampled writing-data signal read by the host from the training register is consistent with the reference writing-data signal, to obtain a trained circuit; and
an adjustment module, configured to adjust, through the trained circuit, a temporal offset applied on an inputted writing-data signal to obtain a target writing-data signal, wherein the target writing-data signal is aligned with a sampling edge of the sampling signal, and the target writing-data signal is configured to be written into the memory.

17. A computer device, comprising a memory and one or more processors, the memory storing a computer-readable instruction, the one or more processors implementing the method of any one of claims 1 to 15 when executing the computer-readable instruction.

18. One or more computer-readable storage media, having computer-readable instructions stored therein, the computer-readable instructions, when executed by one or more processors, implementing the method according to any one of claims 1 to 15.

19. A computer program product, comprising computer-readable instructions, the computer-readable instructions, when executed by one or more processors, implementing the method according to any one of claims 1 to 15.
